Europäisches Patentamt

European Patent Office

Office européen des brevets

(19)

(11) **EP 1 082 725 B1**

(12) **EUROPÄISCHE PATENTSCHRIFT**

(45) Veröffentlichungstag und Bekanntmachung des Hinweises auf die Patenterteilung:
**02.10.2002   Patentblatt 2002/40**

(51) Int Cl.[7]: **G11C 11/15**, G11C 11/16

(21) Anmeldenummer: **99927776.7**

(86) Internationale Anmeldenummer:
**PCT/EP99/03668**

(22) Anmeldetag: **27.05.1999**

(87) Internationale Veröffentlichungsnummer:
**WO 99/062069 (02.12.1999 Gazette 1999/48)**

(54) **MRAM-SPEICHER SOWIE VERFAHREN ZUM LESEN/SCHREIBEN DIGITALER INFORMATION IN EINEN DERARTIGEN SPEICHER**

MAGNETORESISTIVE RANDOM ACCESS MEMORY AND METHOD FOR READING/WRITING DIGITAL INFORMATION TO SUCH A MEMORY

MEMOIRE MAGNETIQUE A ACCES DIRECT (MRAM) ET PROCEDE DE LECTURE/ECRITURE D'INFORMATIONS NUMERIQUES DANS UNE TELLE MEMOIRE

(84) Benannte Vertragsstaaten:
**DE FR GB IT**

(30) Priorität: **28.05.1998   DE 19823826**

(43) Veröffentlichungstag der Anmeldung:
**14.03.2001   Patentblatt 2001/11**

(73) Patentinhaber: **Hillebrands, Burkard Prof. Dr.**
**67661 Kaiserslautern (DE)**

(72) Erfinder:
• **HILLEBRANDS, Burkard**
**D-67661 Kaiserslautern (DE)**
• **STAMPS, Robert, Leon**
**Claremount, W.A. 6907 (AU)**

(74) Vertreter: **Dr. Weitzel & Partner**
**Friedenstrasse 10**
**89522 Heidenheim (DE)**

(56) Entgegenhaltungen:
**US-A- 5 448 515**

• **EVERITT B A ET AL: "SIZE DEPENDENCE OF SWITCHING THRESHOLDS FOR PSUEDO SPIN VALVE MRAM CELLS" JOURNAL OF APPLIED PHYSICS, Bd. 81, Nr. 8, PART 02A, 15. April 1997 (1997-04-15), Seiten 4020-4022, XP000702728 ISSN: 0021-8979**
• **DATABASE INSPEC [Online] INSTITUTE OF ELECTRICAL ENGINEERS, STEVENAGE, GB TEHRANI S ET AL: "High density pseudo spin valve magnetoresistive RAM" Database accession no. 6181636 XP002114391 & SEVENTH BIENNIAL IEEE INTERNATIONAL NONVOLATILE MEMORY TECHNOLOGY CONFERENCE. PROCEEDINGS (CAT. NO.98EX141), SEVENTH BIENNIAL IEEE INTERNATIONAL NONVOLATILE MEMORY TECHNOLOGY CONFERENCE. PROCEEDINGS, ALBUQUERQUE, NM, USA, 22-24 JUNE 1998, Seiten 43-46, 1998, New York, NY, USA, IEEE, USAISBN: 0-7803-4518-5**

**Beschreibung**

Die Erfindung betrifft eine digitale magnetische Speicherzelleneinrichtung für Lese- und/oder Schreiboperationen mit einer ersten und einer zweiten magnetischen Schicht, deren Magnetisierungen zur Speicherung digitaler Information zueinander parallel oder antiparallel ausgerichtet ist, wobei mindestens eine der magnetischen Schichten eine magnetische Anisotropie aufweist gemäß dem Oberbegriff des Anspruches 1 sowie ein Verfahren zum Lesen/Schreiben digitaler Information in eine digitale Speicherzelleneinrichtung gemäß Anspruch 10. Des weiteren wird eine digitale Speichereinrichtung umfassend eine Vielzahl von Speicherzelleneinrichtungen und ein Verfahren zum Lesen/Schreiben digitaler Information in eine derartige digitale Speichereinrichtung offenbart.

Derzeit werden eine Vielzahl magnetischer Speicher mit wahlfreiem Zugriff (MRAM) entwickelt.

Ein MRAM umfaßt eine Vielzahl von magnetischen Speicherzelleneinrichtungen. Jede Speicherzelleneinrichtung umfaßt mindestens zwei magnetische Schichten, die durch eine Zwischenschicht getrennt sind. Die beiden magnetischen Schichten können zueinander parallel oder antiparallel magnetisiert sein. Die beiden vorgenannten Zustände stellen jeweils ein Bit von Information dar, d.h. den logischen Null ("0")- oder Eins ("1")-Zustand. Ändert sich die relative Orientierung der Magnetisierung der beiden Schichten von parallel nach antiparallel oder umgekehrt, so ändert sich der Magnetowiderstand typischerweise um einige Prozent. Diese Änderung des Widerstands kann für das Auslesen in der Speicherzelle abgelegter digitaler Information verwendet werden. Die Änderung des Zellwiderstandes kann durch eine Spannungs- oder Stromänderung je nach Beschaltung erkannt werden. Beispielsweise kann bei Spannungszunahme die Zelle mit einer logischen Null ("0") und bei einer Spannungsabnahme die Zelle mit einer logischen Eins ("1") belegt werden.

Magnetische Speicherzellen, die den Magnetowiderstandseffekt für die Speicherung digitaler Information verwenden, sind aus einer Vielzahl von Schriften bekanntgeworden.

Diesbezüglich wird verwiesen auf:

- EP 0 614 192
- US 5 343 422
- EP 0 685 849
- EP0759619
- US 5 448 515
- US 5 276 639
- US 565 0 958

Besonders große Widerstandserhöhungen im Bereich von einigen Prozent wurden bei Änderung der Magnetisierungsausrichtung von parallel nach antiparallel und umgekehrt in Zellstrukturen mit einem Riesenmagnetowiderstandseffekt (giant magneto resistance effect) (GMR) oder dem Tunnelmagnetowiderstandseffekt beobachtet. Derartige Zellstrukturen sind beispielsweise aus

- M. N. Baibich, J. M. Broto, A. Fert, F. Nguyen Van Dau, F. Petroff, P. Eitenne, G. Creuzet, A. Friederich und J. Chazelas "Giant Magnetoresistance of (001)Fe/(001)Cr Magnetic Superlattices", Physical Review Letters, Vol. 61, Nr. 21, S. 2472 ff. sowie
- Teruya Shinjo, Hidefumi Yamamoto "Large Magnetoresistance of Field-Induced Giant Ferrimagnetic Multilayers", Journal of The Physical Society of Japan, Vol. 59, No. 9, S. 3061-3064;
- WO 95/10112
- WO 96/25740
- EP 0 759 619 sowie
- DE 197 17 123

bekanntgeworden.

Ein wichtiger Vorteil von magnetischen Speicherzellen, wie oben beschrieben, ist darin zu sehen, daß auf diese Art und Weise, beispielsweise gegenüber herkömmlichen Halbleiterspeichern, die Information persistent gespeichert ist, somit nach dem Ausschalten und Wiedereinschalten des Gerätes, in welchem die Speicherzellen verwendet werden, die gespeicherte Information sofort verfügbar ist. Weiterhin werden sehr strahlungsresistente bzw. strahlungsfeste Speichermedien erhalten.

Aus der DE 195 34 856 ist eine digitale Speichereinrichtung für Leseund/oder Schreiboperationen bekanntgeworden, die eine erste magnetische Schicht und eine zweite magnetische Schicht aufweist sowie eine dazwischenliegende Trennschicht und Leiterbahnen zum Leiten von Leseund/oder Schreibströmen, wobei eine über die Zeitspanne des fließenden Stroms andauernde Richtungsänderung der Magnetisierung in einer der beiden Schichten bewirkt wird.

Nachteilig an der digitalen Speichervorrichtung gemäß der DE 195 34 856 ist, daß die Adressierung der Speicherzelle bzw. einzelner Speicherzellen einer Speicherzellenmatrix in einer MRAM-Anordnung alleine durch die Lage der Speicherzelle im Kreuzungspunkt zweier stromtragender Zuführungen geschieht. Bei dem Verfahren gemäß dem Stand der Technik addiert sich das Magnetfeld in den Zuführungsleitungen vektoriell im Kreuzungsbereich und ermöglicht hierdurch die Ummagnetisierung in der angesprochenen Speicherzelle. Dieses Verfahren ist mit Blick auf die Zeitdauern, insbesondere kurzer bzw. ultra kurzer Zeitdauern keinesfalls optimal, insbesondere ergibt sich bei mehreren hintereinandergeschalteten Speicherzellen das Problem, daß die Koerzitivfelder der einzelnen MRAM-Speicherzellen aufgrund von Irregularitäten, beispielsweise Pinning-Zentren, eine gewisse Streuung aufweisen.

Hierdurch ergibt sich, insbesondere bei Zusammenfassung einer Vielzahl solcher aus der DE 195 34 856 bekannten Speicherzelleneinrichtungen zu einer Speichereinrichtung, beispielsweise in Matrixform, daß nicht nur die gewünschte Speicherzelle im Kreuzungspunkt angesprochen wird, sondern auch benachbarte Zellen.

Aus der US 5 448 515 ist eine magnetische Speichereinrichtung bekannt geworden, die eine Vielzahl von Speicherzellen umfaßt und bei der mit Hilfe von Stromimpulsen durch Ummagnetisierung in den adressierten Speicherzellen Informationen eingeschrieben und gelesen werden können.

Nachteilig an dieser Speichereinrichtung war, daß das Einschreiben mit Strömen bzw. Stromimpulsen unspezifizierter Zeitdauer erfolgte und Schreib- und Leseleitung stets einen Winkel von 90° einschließen.

Bei der aus der US 5 276 639 bekannten Speichereinrichtung handelt es sich um eine supraleitende Magnetspeichereinrichtung. Auch bei dieser Magnetspeichereinrichtung werden zum Einschreiben und Auslesen von Informationen Stromimpulse mit langer Zeitdauer von mehr als 15 ns verwandelt.

EVERITT B A ET AL: 'SIZE DEPENDENCE OF SWITCHING THRESHOLDS FOR PSEUDO SPIN VALVE MRAM CELLS' JOURNAL OF APPUED PHYSICS, Bd. 81, Nr. 8, PART 02A, 15. April 1997 (1997-04-15), Seiten 4020-4022; ISSN: 0021-8979 ist eine digitale magnetische Speicherzelleneinrichtung als nächstliegender Stand der Technik bekanntgeworden, die die Merkmale 1.-1.6 des Anspruchs 1 aufweist.

Aufgabe der Erfindung ist es, die zuvor beschriebenen Nachteile des Standes der Technik zu vermeiden, insbesondere eine magnetische Speicherzelleneinrichtung anzugeben, bei der der Umschaltprozeß sowohl in zeitlicher Hinsicht optimiert ist als auch bezüglich der Auswahl der jeweiligen Zelle, d.h. auch sehr kurze Schaltzeiten realisiert werden können. Insbesondere soll bei Zusammenfassung einer Vielzahl von Speicherzellen bzw. Speicherzelleneinrichtungen zu einer digitalen Speichereinheit, beispielsweise in Matrixform bzw. einem Array ein sicheres und schnelles Schalten der adressierten Zelle erreicht werden, selbst wenn die Materialeigenschaften von Zelle zu Zelle im Rahmen der Toleranzen schwanken.

Ein weiterer Aspekt der Erfindung ist die Angabe eines Verfahrens zum optimierten Umschalten einer derartigen Speicherzelleneinrichtung. Außerdem wird angestrebt, die zum Umschalten erforderliche Leistungsaufnahme und damit die von einem Baustein abzuführende Verlustwärme zu minimieren.

Die Aufgabe wird erfindungsgemäß dadurch gelöst, daß bei einer digitalen magnetischen Speicherzelleneinrichtung gemäß Anspruch 1 die Umschaltmittel Einrichtungen zum Erzeugen von Strömen und/oder Strompulsen auf einer ersten und einer zweiten Leiterbahn von mindestens zwei sich kreuzenden Leiterbahnen umfassen, wobei die Leiterbahnen sich unter einem vorbestimmten Winkel kreuzen, so daß in der Speicherzelleneinrichtung im Kreuzungsbereich mit Strompulsen mit einer Zeitdauer von < 10 ns ein vollständiges und sicheres Umschalten der Magnetisierung von einer parallelen in eine antiparallele Ausrichtung erreicht wird.

Werden Taktzeiten von 10 ns entsprechend 100 MHz und schneller für MRAM-Speicher angestrebt, so beträgt die Länge eines Feldpulses zum Einschreiben der digitalen Information beispielsweise maximal 5 ns. Auch bei derart kurzen Pulsdauem muß bei unmittelbar aufeinanderfolgenden Schreibvorgängen ein stabiles Schalten erzielt werden. Das erfindungsgemäße Verfahren stellt ein schnelles Schalten von MRAM-Speicherzellen zur Verfügung, welches den Bedingungen

(i) hohe Stabilität des Schaltvorganges gegen Schwankungen der Material- und Pulsparameter,
(ii) hohe Unempfindlichkeit gegen unerwünschtes Schalten von Nachbarzellen und von Zellen unter den Adreßleitungen,
(iii) hohe Stabilität des Schaltvorganges auch bei unmittelbar aufeinanderfolgenden Schaltvorgängen einer einzelnen Zelle und
(iv) schnelle Schaltzeiten

genügt.

Wird ein Magnetfeld an eine Speicherzelle angelegt, so präzidiert die Richtung der Magnetisierung um die Richtung des in der Schicht wirkenden Feldes.

Es ist das Verdienst der Erfinder, zur Lösung der erfindungsgemäßen Aufgabe folgendes erkannt zu haben:

Ist die Dauer des zum Schalten angelegten Magnetfeldpulses sehr groß, d.h. typischerweise größer als 5 ns, so finden während des Anliegens des Schaltpulses sehr viele Präzessionsumläufe statt, und das Schalten wird durch dissipative Mechanismen, beschrieben durch eine Dämpfungskonstante $\alpha$, bestimmt. Energetisch wird die durch Anlegen des externen Feldes eingebrachte Zeeman-Energie durch einen Dämpfungsmechanismus dissipiert.

Ist die Pulslänge kurz, typischerweise kürzer als 5 ns, so wird das Ummagnetisierungsverhalten wesentlich und mit weiter abnehmender Pulslänge noch zunehmend stärker durch das Präzessionsverhalten der Magnetisierung bestimmt. Bis zum Ende des Feldpulses ist die Präzession kaum gedämpft, und die Richtung der Magnetisierung, und damit der Inhalt der einzuschreibenden Information hängt in hohem Maße davon ab, in welche Richtung die Magnetisierung beim Ende des angelegten Feldpulses liegt, so daß die aus dem Stand der Technik bekannten Speicherzelleneinrichtungen und Lese-/Schreibverfahren kein stabiles Schaltverhalten, insbesondere bei schwankenden Material- und Pulsparametern aufweisen.

Der Schaltprozeß in einer magnetischen Speicherzelle kann durch die Gilbert-Form der Landau-Lifschitz-Gleichung beschrieben werden:

$$\frac{\partial \vec{M}}{\partial t} = -\gamma \vec{M} \times \vec{H}_{eff} + \frac{\alpha}{M_s} \vec{M} \times \frac{\partial \vec{M}}{\partial t} \tag{1}$$

Diesbezüglich wird beispielsweise auf T.L. Gilbert, Phys. Rev. 100, 1243 (1955) verwiesen.

Der erste Term der rechten Seite von Gleichung (1) beschreibt die Präzession des Magnetfeldes, der zweite Term die Dämpfung, wobei $\alpha$ ein phänomenologischer Dämpfungsparameter ist.

Das effektive Feld

$$\vec{H}_{eff}$$

wird definiert durch die Summe aller Felder, die auf die Magnetisierung wirken:

$$\vec{H}_{eff} = \vec{H}_{ext} + \vec{H}_{ani} + \vec{H}_{shape} \tag{2}$$

$$\vec{H}_{ani} = \left| \vec{H}_{ani} \right| \frac{M_x}{M_s} \hat{x} \tag{3}$$

$$\vec{H}_{shape} = -(4\pi N_x M_x \hat{x} + 4\pi N_y M_y \hat{y} + 4\pi N_z M_z \hat{z}) \tag{4}$$

wobei

$\vec{H}_{ext}$ :  extern angelegtes Pulsfeld

$\vec{H}_{ani}$ :  das maximale anisotrope Feld ist, wobei bei der vorliegenden Betrachtung die leichte Achse der Magnetisierung in x-Richtung liegt.

$N_i$ (i = x, y, z)  sind die Diagonalelemente des Demagnetisierungstensors in Diagonalform

$M_x$, $M_y$, $M_z$  die Komponenten des Magnetisierungsvektors in x, y und z-Richtung.

Lösungen der Gleichung (1) können beispielsweise mit Hilfe eines Runge-Kutta-Algorithmuses wie in J. R. Dormand, P. J. Prince, J. Computat. and Appl. Mat. 7, 67 (1981) aufgefunden werden.

Durch entsprechende Auswahl des Verhältnisses der Ströme in den beiden stromtragenden Leitungen sowie der Pulsdauem kann ein vorbestimmter Winkel $\theta$ des Magnetfeldes gegenüber der leichten Richtung der Magnetisierung voreingestellt werden. Wird die Pulsdauer und der Winkel $\theta$ wie später beschrieben eingestellt, so wird auch bei sehr kurzen Schaltpulsen < 10 ns, insbesondere < 5 ns stabiles und vollständiges Umschalten der Speicherzelle erreicht.

In einer besonders vorteilhaften Ausgestaltung der Erfindung werden die Pulsdauern so gewählt, daß das vollständige Umschalten gleichzeitig bei minimaler Leistungsaufnahme erreicht wird.

In einer ersten Ausführungsform der Erfindung werden auf den Leitungen unipolare Pulse angelegt mit einer vorbestimmten Pulsdauer.

In einer zweiten Ausführungsform werden anstelle unipolarer Pulse auf beiden Leitungen auf einer Leitung bipolare Pulse angelegt und auf der anderen Leiterbahn ein statischer Strom oder Strompuls. Der bipolare Puls ist in der Länge der ersten Halbwelle genau auf die Umschaltzeit der Speicherzelleneinrichtung abgestimmt und koppelt resonant an das Umschalten der Magnetisierung an. Er liegt auf der Schreibleitung an, in der ein Magnetfeld senkrecht zur leichten Richtung der Magnetisierung in der umzuschaltenden Schicht erzeugt wird. Auf der anderen Leiterbahn liegt ein statischer Strom oder ein Strompuls, dessen Länge größer als die Halbwellenzeit des bipolaren Pulses ist, an. Dieser erzeugt ein zum Umschaltfeld senkrechtes Magnetfeld.

In einer besonders einfachen Konfiguration sind die Leiterbahnen derart angeordnet, daß sie in der Speicherzelleneinrichtung senkrecht zueinander stehen, d.h. sich unter einem rechten Winkel kreuzen.

Auch andere Winkel $\beta \neq 90°$ unter denen sich die Leiterbahnen kreuzen sind möglich. Beispielsweise kann für bestimmte Pulsdauern mit Vorteil vorgesehen sein, daß die sich kreuzenden Leitungen zumindest auf einem Teilabschnitt parallel verlaufen, d.h. $\beta = 0°$ ist oder eine der beiden Leiterbahnen diagonal über die Speichermatrix verläuft, d. h. $\beta \approx 45°$.

Bevorzugt wird die magnetische Anisotropie der Schichten, die Grund für das Ausbilden einer Richtung der leichten Magnetisierung ist, mit Hilfe von Wachstumsprozessen und/oder einer Formanisotropie, beispielsweise einer ellipsenförmigen Umrandung der Schichten, erhalten. Besonders bevorzugt ist es, wenn die Magnetisierung nur in einer Schicht umgeschaltet werden muß, während sie in der anderen Schicht auch bei Schaltpulsen beibehalten wird. Ein derartiges Verhalten erreicht man dadurch, daß in einer weitergebildeten Ausführungsform der Erfindung die eine der beiden magnetischen Schichten magnetisch härter als die andere ist, beispielsweise dadurch, daß die eine der Schichten eine größere Dicke als die andere aufweist oder eine der Schichten Kontakt zu einer antiferromagnetischen Schicht hat. In einer besonders einfachen Ausgestaltung der Erfindung liegt im Kreuzungsbereich eine der Leiterbahnen parallel zur Richtung der leichten Magnetisierung.

Neben der zuvor beschriebenen Speicherzelleneinrichtung, stellt die Erfindung auch ein Verfahren zum Schreiben digitaler Information in eine derartige Speicherzelleneinrichtung zur Verfügung. Das erfindungsgemäße Verfahren zeichnet sich dadurch aus, daß auf den beiden Leiterbahnen Ströme und/oder Strompulse mit einer Pulsdauer < 10 ns angelegt werden, so daß im Kreuzungsbereich der Leiterbahnen durch die Strompulse ein Magnetfeld unter einem Winkel $\theta$ gegenüber der Richtung der leichten Magnetisierung aufgebaut wird, wodurch die relative Orientierung der Magnetisierung geändert und damit Informationen in eine Speicherzelle eingeschrieben werden können.

In einer ersten Ausführungsform der Erfindung können die Strompulse unipolare Strompulse sein. In einer zweiten weitergebildeten Ausführungsform ist der Strompuls, der auf der Leiterbahn anliegt, bei der der Stromfluß ein Magnetfeld senkrecht zur Richtung der leichten Magnetisierung erzeugt, ein bipolarer Strompuls, und auf der anderen Leiterbahn liegt ein Strom bzw. Strompuls vorzugsweise mit einer Zeitdauer, die größer als die Halbwellendauer des bipolaren Strompulses ist, an. Die Halbwellendauer beträgt bevorzugt weniger als 10 ns.

In einer vorteilhaften Ausführungsform ist vorgesehen, die Einstellung des Winkels $\theta$ zur Richtung der leichten Magnetisierung durch Wahl des Verhältnisses der Stromstärken der Strompulse zueinander vorzunehmen.

Die erfindungsgemäße Speicherzelleneinrichtung ist in einer vorteilhaften Ausführungsform Teil einer digitalen Speichereinrichtung mit einer Vielzahl derartiger Speicherzelleneinrichtungen. Jede der Speicherzelleneinrichtungen weist mindestens zwei sich kreuzende Leiterbahnen auf. Bevorzugt können die Speicherzelleneinrichtungen als Array in Matrixform angelegt sein.

In einer Ausführungsform der Erfindung sind einer Mehrzahl von in Reihen oder Spalten angeordneten Leiterbahnen gemeinsame Umschaltmittteln zugeordnet.

In einer besonders einfachen Ausführungsform kann die magnetisch härtere Schicht der einzelnen Speicherzelleneinrichtungen sich über mehrere Zellen hinweg erstrecken.

Bei einer derartigen digitalen Speichereinrichtung kann das erfindungsgemäße Verfahren zum Ummagnetisieren einer Speicherzelleneinrichtung mit besonderem Vorteil angewandt werden. Insbesondere ermöglicht ein derartiges Verfahren eine exakte Adressierung der einzelnen Speicherzellen der Matrix aufgrund einer Selektion derjenigen Speicherzelle über eine Zeitskala, bei der der resultierende Feldpuls unter einem Winkel $\theta$ anliegt, was genau im Kreuzungsbereich zwei sich kreuzender stromtragender Leitungen der Fall ist. Die Ummagnetisierung erfolgt dann durch eine Rotation der Magnetisierung aus der antiparallelen in die parallele Ausrichtung bzw. Orientierung oder umgekehrt. Bei den kurzen Schaltzeiten gemäß der Erfindung ist der Winkel $\theta$, unter dem das Schaltmagnetfeld anliegt, von entscheidender Bedeutung, da bis zum Ende des Feldpulses die Präzession kaum gedämpft ist und die durch Anlegen des Feldpulses in das System eingebrachte Zeeman-Energie um stabiles Schalten zu erreichen, wieder in Form von Zeeman-Energie aus dem System genommen werden muß. Wird dies eingehalten, so wird mit dem erfindungsgemäßen Verfahren aufgrund der Pulsdauer und gegebenenfalls der Stromstärke nur die im Kreuzungsbereich der stromführenden Leitungen liegenden Zellen ausgewählt werden, d.h. das Umschalten erfolgt ohne Beeinflussung benachbarter Zellen. Diese behalten ihre Magnetisierung trotz der Schaltpulse bei. Schwankungen der Pulsbreite bzw.

-dauer und von Materialeigenschaften beeinflussen die Stabilität des Schaltens deutlich geringer.

Die Erfindung wird nachfolgend anhand der Figuren und Ausführungsbeispiele näher beschrieben.

Es zeigen:

Fig. 1a          einen Schnitt durch eine erfindungsgemäße Speicherzelleneinrichtung;

Fig. 1b          eine Draufsicht auf eine erfindungsgemäße Speicherzelleneinrichtung;

Fig. 2           ein Array aus Speicherzelleneinrichtung gemäß Fig. 1;

Fig. 3a - 3d     Bereiche von Schalten und Nichtschalten in Abhängigkeit von Pulsdauer und Feldstärke für mit β = 90° bzw. β≈ 45° sich kreuzende Leitungen;

Fig. 3e          Bereiche stabilen Schaltens für eine Pulsdauer von t = 0,25 ns und parallelen Adressleitungen;

Fig. 4a - 4e     Bereiche von Schalten und Nichtschalten für Rechteckpulse mit t = 2,75 ns;

Fig. 5a - 5e     Bereiche von Schalten und Nichtschalten für Rechteckpulse mit t = 0,25 ns;

Fig. 6a - 6e     Bereiche von Schalten und Nichtschalten für unterschiedliche Pulsformen und Pulsdauern;

Fig. 7           einen Schnitt durch eine erfindungsgemäße Speicherzelle mit Angabe eines Koordinatensystems;

Fig. 8a, 8b      Verlauf der Magnetisierung in den unterschiedlichen Koordiantenachsen bei Anlegen von unipolaren Pulsen unterschiedlicher Stromstärke ergebend einen unterschiedlichen Winkel θ;

Fig. 9a, 9b      Verlauf der Magnetisierung bei fest vorliegendem Winkel θ und unterschiedlichen Zeitdauern der unipolaren Pulse;

Fig. 10a,10b     Verlauf der Magnetisierung in zu der angesprochenen Speicherzelle mit kreuzenden Leitungen benachbarten Speicherzellen.

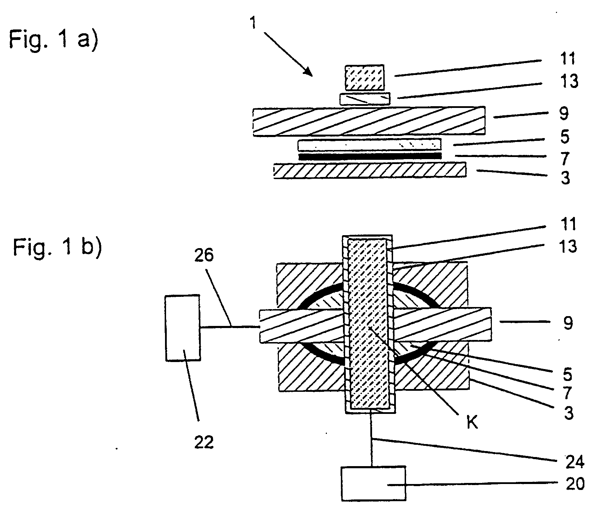

Figur 1 zeigt in einem Schnitt (Figur 1a) und in einer Draufsicht (Figur 1b) eine erfindungsgemäße digitale Speicherzelleneinrichtung.

Die erfindungsgemäße digitale Speicherzelleneinrichtung umfaßt eine erste magnetische Schicht 3 sowie eine zweite magnetische Schicht 5 mit dazwischenliegender nichtmagnetischer Trennschicht 7. Bei der ersten magnetischen Schicht sowie bei der zweiten magnetischen Schicht handelt es sich im wesentlichen um eine permanent- bzw. ferromagnetische Schicht. Ein bevorzugter Schichtaufbau sind beispielsweise Co-Cu-Co- oder Fe-Cr-Feoder Fe-Cr-Fe- oder NiFe-Cu-NiFe-Schichtsysteme umfassend die erste magnetische Schicht 3, die nichtmagnetische Zwischenschicht 7 sowie die zweite magnetische Schicht 5. Diese Systeme werden als GMR-Systeme bezeichnet. Besonders bevorzugt finden bei der Erfindung magnetische Tunnelsysteme Anwendung, die beispielsweise folgenden Schichtaufbau haben können:

$$Co - Al_2O_3 - NiFe$$
$$NiFe - Al_2O_3 - NiFe$$

Betreffend GMR-Schichtsystem wird insbesondere auf die DE 195 34 856, betreffend die Tunnelstrukturen auf die US 5 650 958 verwiesen.

Die beiden permanent- bzw. ferromagnetischen Schichten 3, 5 sind nur einige nm dick, ebenso die nichtmagnetische Zwischenschicht 7. Vorzugsweise hat die zweite ferromagnetische Schicht 5 eine elliptische Gestalt, wohingegen die untere erste ferromagnetische Schicht 3 eine rechteckige Gestalt aufweist oder als nichtstrukturierte durchgehende Schicht allen Speicherzellen gemeinsam ist. Die magnetisch härtere Schicht 3 könnte in einer alternativen Ausführungsform auch oben angeordnet sein; die magnetisch weichere unten. Aufgrund der durch die elliptische Form aufgeprägten magnetischen Formanisotropie zeigt die Magnetisierung der elliptisch geformten zweiten magnetisch weicheren Schicht 5 in Richtung der langen Achse der Ellipse; d.h. die beiden Magnetisierungen können parallel oder antiparallel zueinander stehen. Die Schichtdicke der Zwischenschicht 7 ermöglicht die Einstellung einer vorbestimmten Kopplung zwischen den beiden magnetischen Schichten 3, 5, wovon in vorliegendem Ausführungsbeispiel eine magnetisch härter als die andere ausgebildet ist, ohne daß dies zwingend für die Erfindung notwendig wäre.

Durch entsprechende Schichtdicke kann man eine sehr geringe Kopplung zwischen den magnetischen Schichten erreichen, so daß die Anisotropie der Speicherzelle im wesentlichen durch die zweite Schicht 5 bestimmt wird.

Besonders bevorzugt ist es, durch geeignete Maßnahmen dafür zu sorgen, daß die Magnetisierung in der ersten Schicht die einmal eingenommene Richtung nicht mehr ändert, so daß die parallele bzw. antiparallele Einstellung der Magnetisierung der beiden Schichten zueinander alleine durch die Ausrichtung der Magnetisierung in der ersten Schicht bestimmt wird.

Die erste Schicht 3 ist somit magnetisch härter als die zweite Schicht 5.

Die wirkungsvollste Maßnahme, die eine der beiden Schichten magnetisch härter als die andere auszubilden, besteht darin, die Schichtdicken der magnetischen Schichten unterschiedlich auszubilden. Beträgt die Schichtdicke der ersten unteren Schicht etwa 10 nm und die der zweiten oberen Schicht beispielsweise nur 1 bis 2 nm, so ist die Koerzitivfeldstärke der ersten Schicht merklich kleiner als die der zweiten Schicht, womit die Magnetisierung in der zweiten Schicht als unveränderbar bzw. eingefroren angesehen werden kann.

Über der obersten zweiten Schicht sind zwei Leiterbahnen 9, 11 ausgebildet, die durch eine Isolierschicht 13 voneinander getrennt werden. Die beiden Leiterbahnen 9, 11 sind vorliegend, ohne Beschränkung hierauf, unter einem Winkel von 90° zueinander angeordnet und kreuzen sich, wie aus Fig. 1b hervorgeht, in Punkt K. Jede der beiden Leiterbahnen 9, 11 ist an eine Einrichtung zum Erzeugen von Strömen bzw. Strompulsen angeschlossen. So ist die Stromerzeugungseinrichtung 20 mit der Leiterbahn 11 und die Stromerzeugungseinrichtung 22 mit der Leiterbahn 9 über Zuleitungen 24, 26 verbunden.

Durch einen Strom bzw. Strompuls durch die Leiterbahn 9 kann ein Magnetfeld senkrecht zur Richtung der leichten Magnetisierung und durch einen Strom bzw. Strompuls durch die Leiterbahn 11 ein Magnetfeld parallel zur Richtung der leichten Magnetisierung aufgebaut werden. Die Leiterbahnen der dargestellten Zelle kreuzen sich im Kreuzungsgelenkpunkt K unter einem rechten Winkel, d.h. $\beta = 90°$. Selbstverständlich sind auch andere Anordnungen denkbar, insbesondere eine Anordnung, bei die Leiterbahnen 9, 11 im Bereich der Speicherzelle parallel zueinander laufen und der Kreuzungspunkt außerhalb der Speicherzelle liegt. Dies kann insbesondere bei sehr kurzen Schaltzeiten unter dem Blickwinkel der Stabilität vorteilhaft sein.

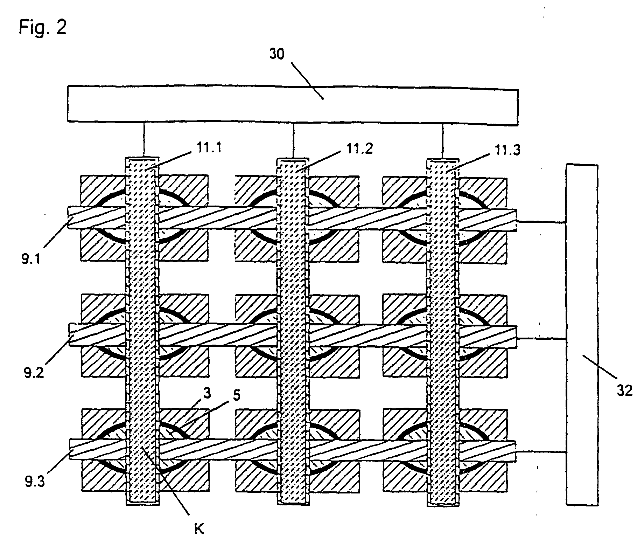

In Figur 2 ist eine digitale Speichereinrichtung aus einer Vielzahl von Speicherzellen gemäß Figur 1 dargestellt. Die einzelnen Speicherzellen sind in Form eines Arrays aufgebaut. Das Array umfaßt eine Vielzahl erster Zuleitungen 11.1, 11.2, 11.3 sowie eine Vielzahl zweiter Zuleitungen 9.1, 9.2 und 9.3, die auf jeder der ersten Zuleitungen senkrecht stehen. Erste und zweite Zuleitungen kreuzen sich jeweils im Bereich einer Speicherzelleneinrichtung. Gleiche Komponenten wie in Figur 1 für eine Speicherzelleneinrichtung sind auch in Figur 2 mit denselben Bezugsziffern belegt.

Jede einzelne der ersten Schreibleitungen 11.1, 11.2 und 11.3 sind über die Strompulseinrichtung 30 ansteuerbar, jede der Zuleitungen 9.1, 9.2 und 9.3 über die Strompulseinrichtung 32. Die Strompulseinrichtungen 30, 32 können wiederum mit einem Mikroprozessor bzw. einer Zentraleinheit oder CPU verbunden sein. Wesentlicher Gedanke der vorliegenden Erfindung ist es, mit Hilfe der Mittel zur Erzeugung von Strompulsen das Umschaltverhalten einer einzigen Speicherzelleneinrichtung, wie in Figur 1 dargestellt, bzw. einer ganzen digitalen Speichereinrichtung, wie ausschnittsweise in Figur 2 dargestellt, durch Optimierung der Zeitstruktur und der Stärke der Strompulse auf den beiden Schreibleitungen zu optimieren. Im Gegensatz zum erfindungsgemäßen Verfahren wird in konventionellen MRAM-Speicheranordnungen die Adressierung der einzelnen Speicherzelleneinrichtungen alleine durch die Lage der Speicherzelle im Kreuzungspunkt der stromtragenden Zuführungen 9, 11 bestimmt. Das Magnetfeld der Zuführungen addiert sich in Kreuzungspunkt K vektoriell und ermöglicht hier die Ummagnetisierung. Problematisch an diesem Verfahren ist, daß die Koerzitivfelder der einzelnen Speicherzelleneinrichtungen aufgrund von Irregularitäten eine gewisse Streuung erfahren, weswegen das Ansprechen nur einer einzigen Zelle mittels Strompulsen auf den Schreibleitungen bei sehr kurzen Impulsen kleiner 10 ns nur schwer zu verwirklichen ist.

Nachfolgend soll das Auffinden eines zum stabilen Schalten geeigneten Parametersatzes in bezug auf Pulsdauer und Stromstärke aufgezeigt werden.

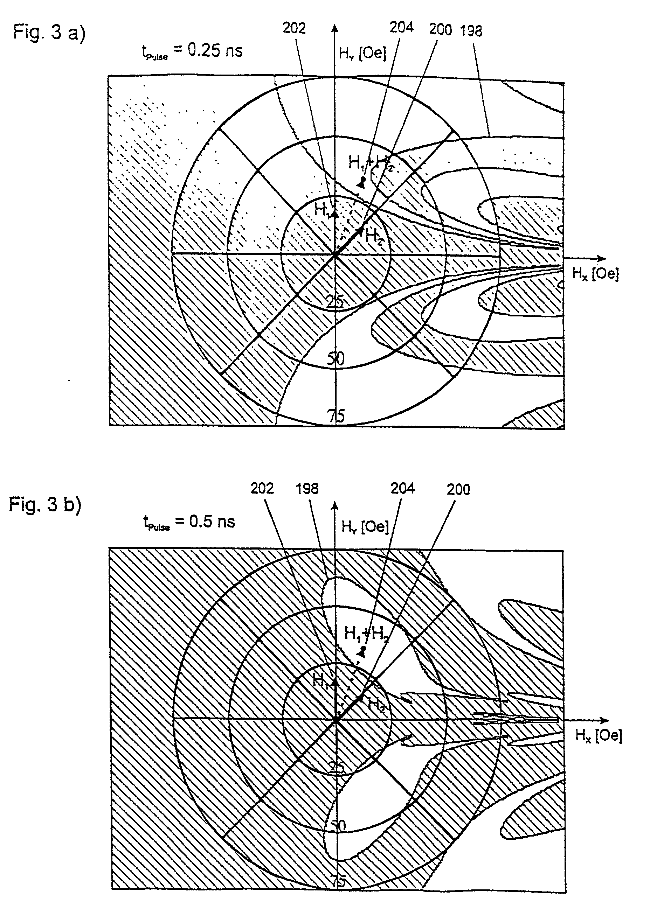

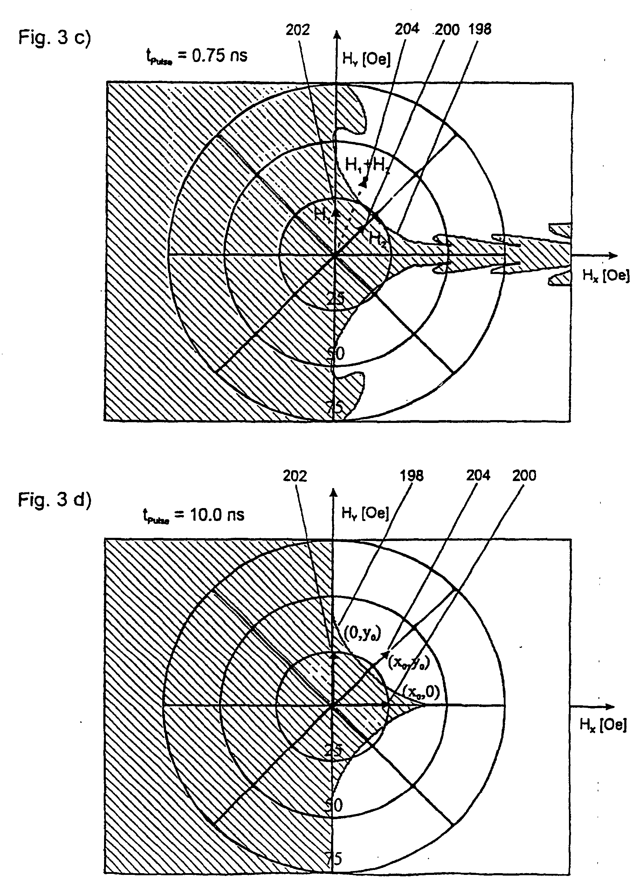

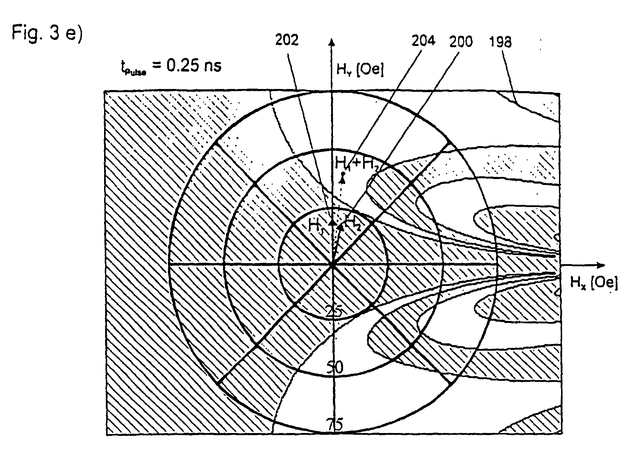

Zum Auffinden wird die in Figur 3a-3d gezeigte zweidimensionale Darstellung verwandt. Vor Anlegen des Pulses möge die Richtung der Magnetisierung in die -x-Richtung, d.h. nach links auf der x-Achse liegen. Figur 3a zeigt nun, ob als Funktion der Richtung und Stärke des Feldpulses ein Schaltvorgang stattgefunden hat. Die nicht schraffierten Bereiche bezeichnen dabei Bereiche, in denen ein Schaltvorgang stattgefunden hat, die schraffierten Bereiche Bereiche in denen kein Schaltvorgang stattgefunden hat. Jeder Punkt in Figur 3a-3d entspricht einem Wert des Schaltpulses, wobei die Richtung vom Mittelpunkt zum konkreten Punkt die Richtung des Feldpulses in der Zelle und der Abstand die Stärke des Feldpulses angibt. Kreise deuten Pulse gleicher Stärke an. Die in Figur 3a-3d dargestellten Bereiche stabilen Schaltens und Nichtschaltens ergeben sich für das Material Permalloy bei Zugrundeliegen nachfolgender Parameter aus der Landau-Lifschitz-Gleichung (1):

$4\pi M_s = 10{,}8 kG$, Dämpfungsfaktor $\alpha = 0.008$, $N_x = 0.008$, $N_y = 0.012$, $N_z = 0.980$, dh. die leichte Achse liegt in x-Richtung.

In Figur 3a-d sind Diagramme für einen Puls langer Dauer ($t = 10$ ns) in Figur 3d und mittlerer ($t = 0.75$ ns) in Figur 3c bzw. kurzer Dauer ($t = 0.5$ ns und $t = 0{,}25$ ns) in Figur 3a und 3b gezeigt. Es ist deutlich zu sehen, daß die Trennlinie bzw. Trennlinien 198 zwischen den Bereichen für Schalten und Nichtschalten empfindlich von der Pulsdauer abhängt.

Für eine gegebene Zellgeometrie können aus Diagrammen wie in Figur 3a bis 3d die möglichen Werte, bei denen stabiles Schalten auftritt, ermittelt werden.

Nachfolgend wird zunächst der Fall betrachtet, daß eine Zelle mittels zwei sich kreuzender Adreßleitungen adressiert wird, d.h. jede Adreßleitung erzeugt, wenn sie Strom trägt, ein Magnetfeld senkrecht zu ihr, in allen unter ihr liegenden Speicherzellen. In der adressierten Speicherzelle im Kreuzungsbereich addieren sich die Magnetfelder der beiden Adreßleitungen dann vektoriell. Nimmt man der Einfachheit halber an, daß beide Adreßleitungen sich unter einem Winkel von $\beta = 90°$ kreuzen, wie beispielsweise in Fig. 3d gezeigt, dann erzeugt die horizontale Adreßleitung ein vertikales Feld, für welches das Schaltverhalten gemäß der Feldstärke auf der y-Achse abgelesen werden kann,

z. B. bei $y_0$. Analog kann für eine vertikale Adreßleitung das Schaltverhalten auf der x-Achse, z.B. bei $x_0$ abgelesen werden. Der Punk $y_0$, der Endpunkt des Feldes auf der horizontalen Adreßleitung ist, ist mit Bezugsziffers 202 belegt, der Punkt $x_0$ der Endpunkt des Feldes auf der vertikalen Adreßleitung ist, mit Bezugsziffer 200. Das Schaltverhalten im Kreuzungsbereich kann unmittelbar bei den Koordinaten $(x_0, y_0)$, der den Endpunkt des resultierenden Feldes bezeichnet und mit Bezugsziffer 204 belegt ist, abgelesen werden. Stabiles Schalten ist erzielt, falls

(i) die Punkte $(\pm x_0, 0)$, $(0, \pm y_0)$ in Bereichen des Nichtschaltens liegen, d.h. die auf den Leitungen anliegenden Pulse führen in Speicherzellen, in denen sich die Leitungen nicht kreuzen, zu keinerlei Umschalten der Magnetisierung der Speicherzelle;

(ii) in der Speicherzelle, in der sich die Leitungen kreuzen, führt der resultierende Feldpuls, der durch den Punkt des Schaltens $(x_0, y_0)$ gekennzeichnet ist, zum Umschalten der Magnetisierung, vorliegend aus der -x- in die +x-Richtung;

(iii) alle Punkte $(\pm x_0, 0)$, $(0, \pm y_0)$ sowie der Punkt des Schaltens $(x_0, y_0)$ sind möglichst weit entfernt von der Trennlinie zwischen Schalten und Nichtschalten plaziert.

Für lange Pulse sind diese Bedingungen unproblematisch, wie Figur 3d zeigt, nicht jedoch für kurze Pulse.

Im dargestellten Fall liegt der Punkt $x_0$, $y_0$ bei den verwendeten Pulsdauem und Stromstärken im Bereich des Schaltens (nichtschraffierter, heller Bereich). Für gegebene Werte der Pulsdauer und Form können mit Hilfe oben beschriebener Methode optimale Werte für die anzusetzenden Pulsstärken für unterschiedliche Pulsdauem gefunden werden, bei der stabiles Schalten erfolgt.

Während zuvor der Winkel $\beta$ zwischen den sich kreuzenden Leitungen 90° bei dem zuvor Beschriebenen und in Fig. 3d beschriebenen Beispiel betrug, seien nachfolgend Fälle betrachtet, in denen der Winkel $\beta$ zwischen den Adreßleitungen von 90° verschieden ist Diese Situation ist in den Figuren 3a - 3c dargestellt Der Winkel beträgt ungefähr 45°. Stabiles Schalten ist erreicht, falls im Diagramm die Endpunkte 200, 202 der Vektoren $\pm \mathbf{H_1}$, $\pm \mathbf{H_2}$ (kein Schalten, schwarze Pfeile) und der Endpunkt 204 des Vektors $\mathbf{H_1} + \mathbf{H_2}$ (Schalten, gestrichelte Pfeile) genügend weit von der Trennlinie 198 zwischen Schalten und Nichtschalten entfemt sind und die Endpunkte 200, 202 der Vektoren $\pm \mathbf{H_1}$, $\pm \mathbf{H_2}$ im Bereich des Nichtschaltens (schraffierte, dunkle Bereiche), der Punkt 204 des Vektors $\mathbf{H_1} + \mathbf{H_2}$ im Bereich des Schaltens (nicht schraffierte, helle Bereiche) liegt

Femer ist es möglich, mittels gleichgerichteter Feldpulse den jeweiligen Magnetisierungszustand umzukehren. Dies ist in Figur 3e gezeigt. Hier laufen im Bereich der adressierten Speicherzelle die beiden Adreßleitungen parallel.

Die Endpunkte 200, 202 der Vektoren $\pm \mathbf{H_1}$, $\pm \mathbf{H_2}$ (kein Schalten) und der Endpunkt 204 $\mathbf{H_1} + \mathbf{H_2}$ (Schalten) sind eingezeichnet, wobei jetzt $\mathbf{H_1}$ und $\mathbf{H_2}$ nahezu parallel zueinander liegen. Es ist unmittelbar der Figur 3e zu entnehmen, daß bei kurzen Pulsdauem von t = 0,25 ns ein sehr stabiles Schalten in den jeweils umgekehrten Zustand bei einer derartigen Anordnung erzielt werden kann, wobei wiederum die Bedingung eines ausreichenden Abstandes von der Trennlinie zwischen Schalten und Nichtschalten eingehalten wird.

Wie anhand von Figuren 3a - 3e dargestellt, kann durch geeignete Wahl der Pulsdauer, der Pulsstärke sowie des Winkels $\beta$ der Adressleitungen zueinander, stabiles Schalten bei kurzen Pulsdauem erreicht werden, da es gelingt, die Präzession beim Pulsende zu unterdrücken.

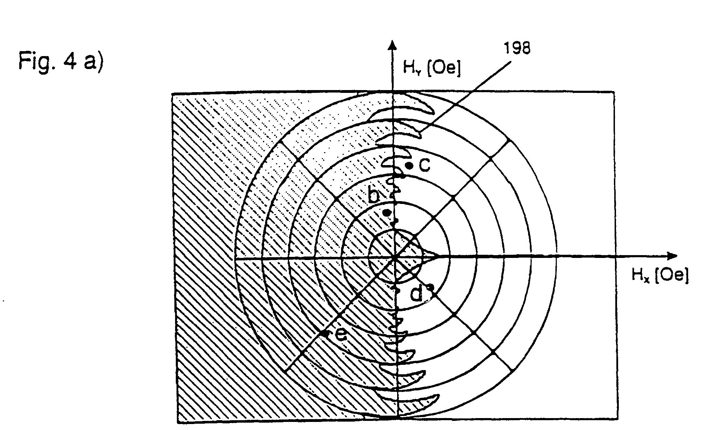

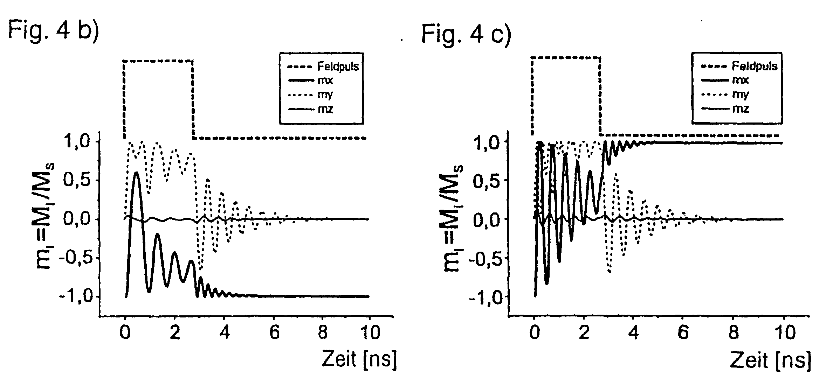

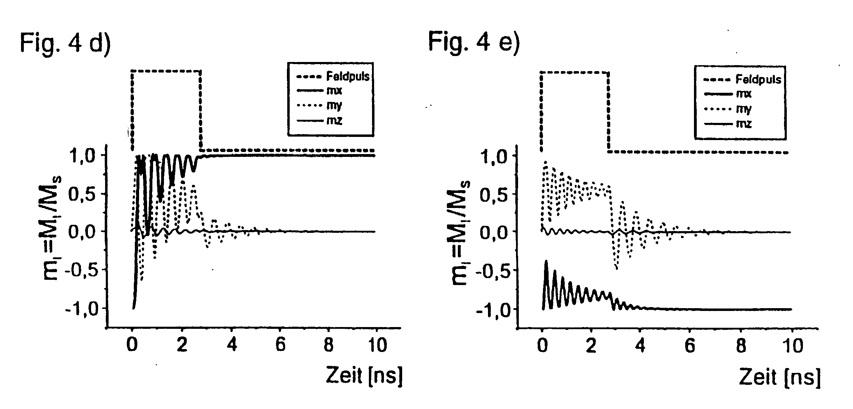

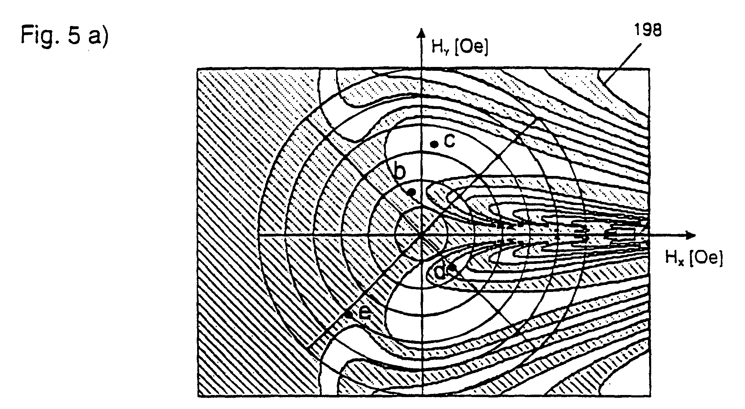

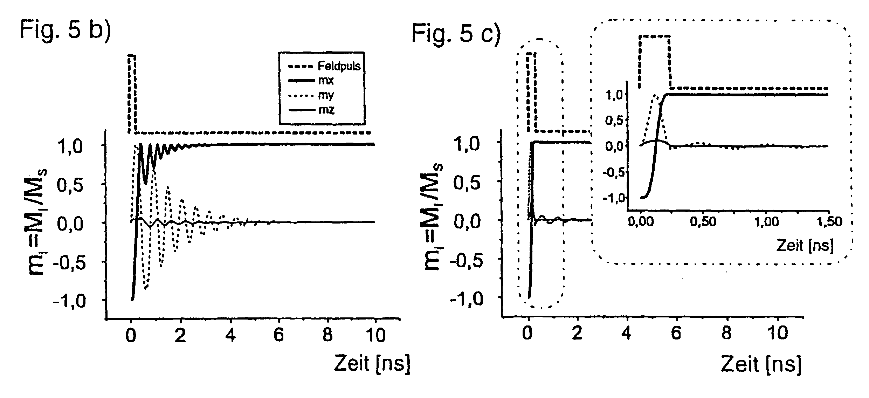

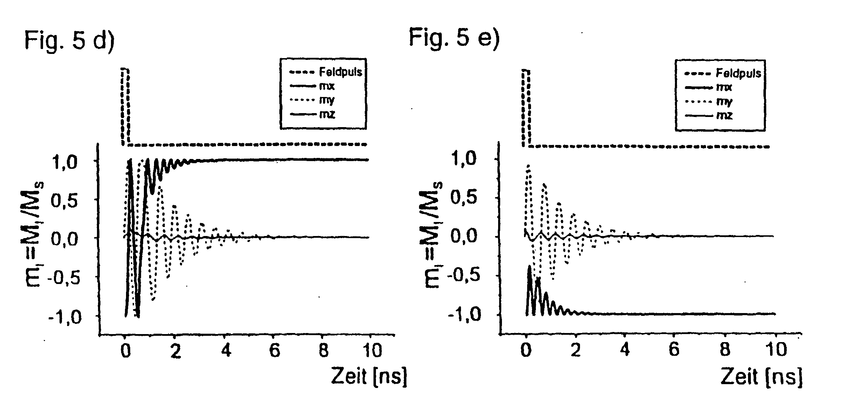

In den nachfolgenden Figuren 4a-e und 5a-e wird für verschiedene Orte in einem zweidimensionalen Diagramm, wie es den Fig. 3a-e zugrundeliegt, die zeitliche Entwicklung der unterschiedlichen Magnetisierungskomponenten $m_x$, $m_y$, $m_z$ gezeigt. In den Diagrammen bezeichnet $m_x$, $m_y$, $m_z$ die auf die Sättigungsmagnetisierung $M_s$ der betrachteten Schicht, vorliegend einer Permalloy-Schicht normierte Magnetisierung $M_x$, $M_y$, $M_z$.

Beim Ausführungsbeispiel gemäß Fig. 4a-4e ist der Feldpuls ein Rechteckpuls mit 2,75 ns Dauer. Vor Anlegen des Feldpulses ist die Magnetisierung in -x-Richtung ausgerichtet. Die nicht schraffierten Bereiche in Fig. 4a bezeichnen das Gebiet erfolgreichen Schaltens der Magnetisierung in die +x-Richtung. Das kreisförmige Koordinatensystem in Fig. 4a ermöglicht die Festlegung von Stärke und Richtung des Feldpulses. Die Stärke des Pulses im Zentrum ist 0; der Abstand benachbarter Kreise des Koordinatensystems beträgt 25 0e. Die vier Diagramme 4b-e zeigen die zeitliche Entwicklung der Magnetisierung $m_x$ $m_y$, $m_z$ in Abhängigkeit von der Lage des resultierenden Feldpulses im Diagramm 4a. Bei allen Pulsen beobachtet man zu Beginn und zum Ende des Feldpulses ein starkes Klingeln; d.h. Ausschwingen der Magnetisierung. Wie aus den Fig 4a-e ersichtlich, wird bei zu kleinen Stärken des resultierenden Feldpulses keinerlei Schalten erreicht.

Die Stärke und Richtung der resultierenden Feldpulse ist für die verschiedenen in den Fig. 4b-e dargestellten Fällen im Diagramm 4a mit den Buchstaben b, c, d, e eingezeichnet.

In den Fällen Fig. 4c, 4d findet ein Umschalten der Magnetisierung aus der -xin die +x-Richtung statt; in den Fällen Fig. 4b, 4e kein Umschalten.

In Fig. 5a-e ist die zeitliche Entwicklung der Magnetisierung $m_x$, $m_y$, $m_z$ für kurze Schaltpulse von 0,25 ns Pulsdauer gezeigt. Die zweidimensionale Darstellung für die resultierenden Feldpulse in Fig. 5a zeigt eine völlig andere Form als für den Fall längerer Pulse von 2,75 ns Dauer gemäß Fig. 4a.

Insbesondere ist Schalten auch möglich mit resultierenden Feldpulsen, die in Richtung der Magnetisierung im nichtgeschalteten Zustand, d.h. in die -x-Richtung zeigen.

Der Endzustand der Magnetisierung ist in den Fällen von Fig. 5c-5e analog zu den Fällen von Fig. 4c-4e. Im Gegensatz zum Fall von Fig. 4b findet gemäß Fig. 5b Schalten statt. Dies ist darauf zurückzuführen, daß der Schaltprozeß bei kurzen Pulslängen von 0,2 - 0,6 ns durch Präzession dominiert wird. Wie sich dieses Verhalten auswirken kann, zeigt insbesondere Fig. 5c. Ein vollständiges Umschalten der Magnetisierung innerhalb der Pulsdauer kann beobachtet werden, wobei keinerlei "Klingeln" auftritt. Die Magnetisierung schaltet auf einer Zeitskala um, die wesentlich kürzer als die Relaxationszeit der Magnetisierung ist. Der Grund für dieses Verhalten ist darin zu sehen, daß der resultierende Feldpuls genau dann auf 0 abfällt, d.h. ausgeschalten wird, wenn die z-Komponente der Magnetisierung die 0 durchläuft. Dies ist aus energetischer Sicht vorteilhaft, da an diesem Punkt die Zeeman-Energie, die aus dem Feld genommen wird, maximal ist.

Für ein ultraschnelles Schalten ist es besonders vorteilhaft, wenn wie im Fall von Fig. 5c ein "Klingeln" völlig unterdrückt werden kann, da die Totzeit dann minimal ist. Dies erlaubt ein schnelles und vollständiges Hin- und Herschalten einer Speicherzelle zwischen den Magnetisierungszuständen in +x- und -x-Richtung in direkt aufeinanderfolgenden Schaltpulsen.

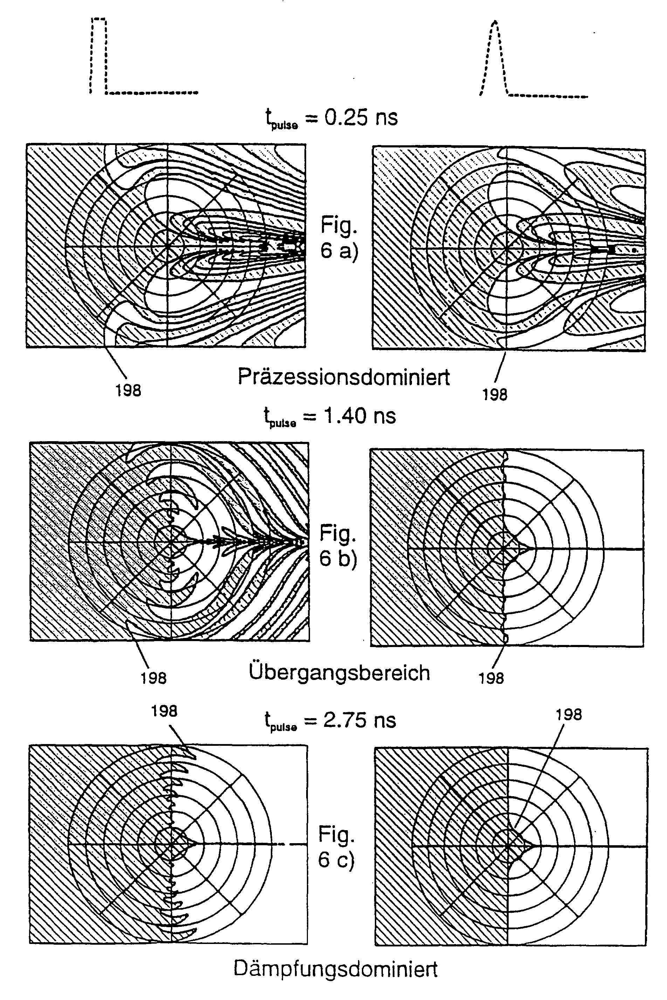

Fig. 6a-6c zeigen den Einfluß der Pulsform auf die Trennlinie 198der Bereiche des Schaltens bzw. Nichtschaltens. Die Magnetisierung liegt wie schon bei allen vorausgegangenen zweidimensionalen Darstellungen vor dem Schalten in -x-Richtung. Es wird von der -x-Richtung in die +x-Richtung geschaltet. Die linke Seite zeigt die Bereiche des Schaltens/Nichtschaltens bei Rechteckpulsform; die rechte Seite die Bereiche des Schaltens/Nichtschaltens bei einem Puls mit einer ansteigenden und einer abfallenden Flanke.

In Fig. 6a beträgt die Pulsdauer 0,25 ns; der Prozeß ist durch die Präzession dominiert.

Fig. 6b zeigt das Übergangsgebiet mit einer Pulsdauer von 1,40 ns.

Fig. 6c zeigt schließlich das durch die Dämpfung dominierte Gebiet mit einer Pulsdauer von 2,75 ns.

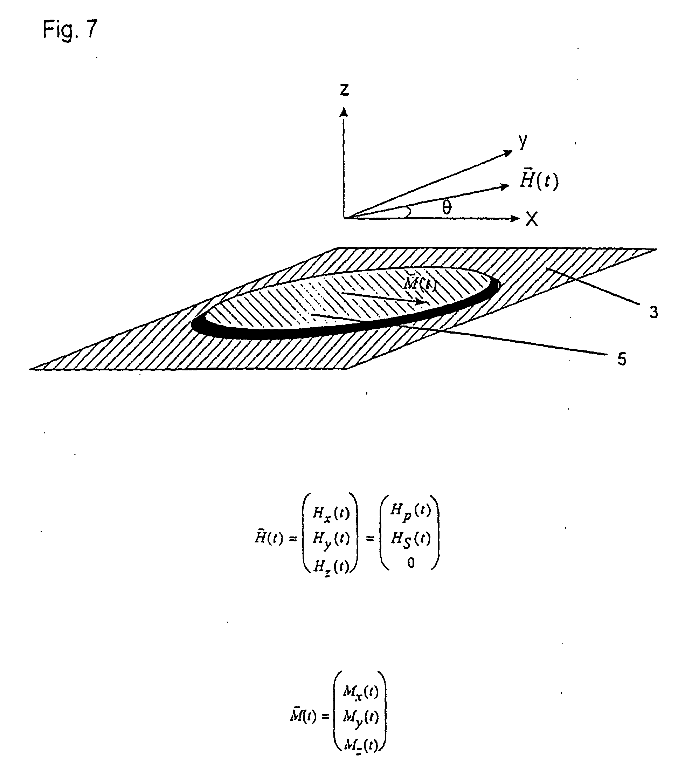

Das Umschaltverhalten mittels der erfindungsgemäßen Strompulse soll nachfolgend detailliert nochmals anhand der Figuren 7 bis 10 verdeutlicht werden.

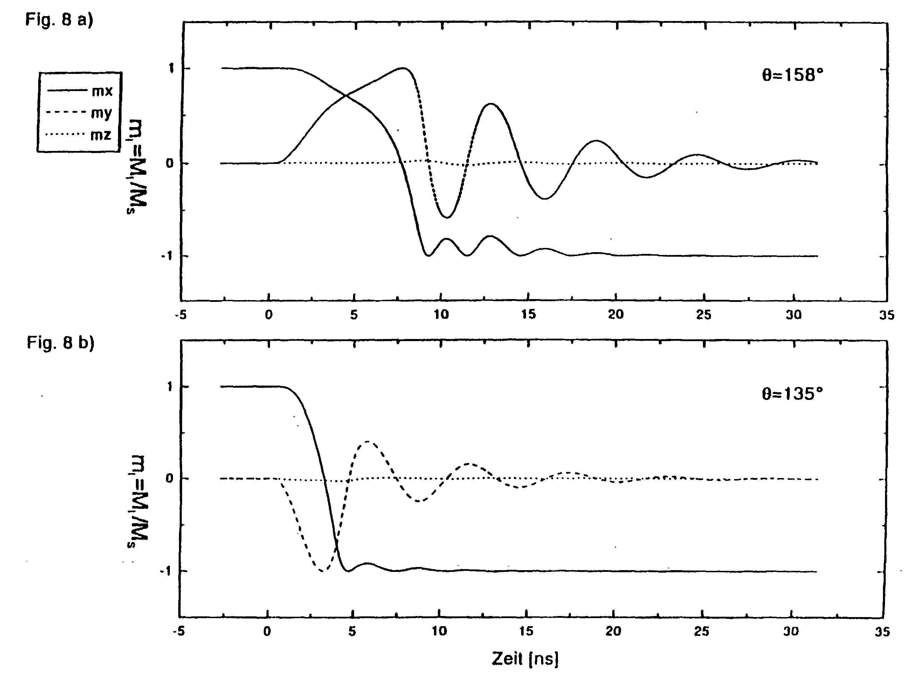

Figur 7 zeigt die in den Figuren 8 bis 9 verwendeten Parameter anhand eines Schnittbildes durch eine Speicherzelleneinrichtung.

Die Speicherzelleneinrichtung umfaßt wiederum eine erste magnetische Schicht 3 sowie eine elliptische zweite magnetische Schicht 5. Die Richtung der leichten Magnetisierung der anisotropen zweiten magnetischen Schicht verläuft entlang der Ellipsenlängsachse mithin in dem eingezeichneten Koordinatensystem entlang der x-Achse H(t).

Die Richtung senkrecht zur leichten Richtung der Magnetisierung wird durch die y-Achse repräsentiert, die senkrechte auf die gesamte Speicherzelle durch die z-Richtung.

Durch die Strompulse auf den Schreibleitungen 9, 11 wird das in Figur 7 angegebene Magnetfeld H(t) erzeugt, das sich aus einer Komponente parallel zur leichten Richtung der Magnetisierung $H_p(t)$ und einer Komponente senkrecht zur leichten Richtung der Magnetisierung $H_s(t)$ zusammensetzt.

Das resultierende Magnetfeld H(t) weist einen Winkel θ zwischen Magnetfeld und leichter Richtung der Magnetisierung auf. In den zweidimensionalen Diagrammen der zuvor beschriebenen Figuren 4-7 war dies der Winkel zwischen dem resultierenden Vektor des Feldpulses in der Speicherzelle, in der sich die Leitungen kreuzen und der x-Achse, die in diesen Beispielen mit der leichten Richtung der Magnetisierung zusammenfiel.

Durch das zeitabhängige Magnetfeld ergibt sich ein zeitabhängiger Verlauf der Magnetisierung m(t), die sich wiederum in Komponenten $m_x(t)$, $m_y(t)$, $m_z(t)$ aufspalten läßt, wie zuvor ausführlich beschrieben.

In Figur 8 ist der Verlauf der Magnetisierung aufgespalten in die drei normierten Komponenten $m_x$, $m_y$, $m_z$ in Abhängigkeit vom Winkel θ, dem das angelegte Feld H(t) mit der leichten Richtung der Magnetisierung einschließt, dargestellt. Wie deutlich zu erkennen, ist das Umschalten von einer ersten, beispielsweise parallelen Ausrichtung der Magnetisierung mit dem normierten Wert 1 zu einer antiparallelen Ausrichtung der Magnetisierung mit einem normierten Wert -1 jeweils in der x-Komponente der Magnetisierung bei einem Winkel von θ = 135° wesentlich schneller erreicht als bei einem Winkel von 158°.

Die Zeitdauer der Pulse betrug im ersten Fall für die Richtung parallel und senkrecht zur leichten Richtung der Magnetisierung 12,4 ns, die Feldstärke $H_p$ -0,005, d.h. -0,5 % der Sättigungsmagnetisierung der weichen Schicht, und die Feldstärke $H_s$ 0,002, d.h. 0,2 % der Sättigungsmagnetisierung der weichen Schicht.

Im in Figur 8b dargestellten Beispiel betrug die Feldstärke $H_p$ -0,005 und die Feldstärke $H_s$ 0,005 ergebend einen Winkel θ von 135°. Die Pulsdauer der unipolaren Pulse betrug sowohl parallel als auch senkrecht zur leichten Richtung der Magnetisierung 5 ns. Deutlich zu erkennen ist das fast doppelt so schnelle Umschalten der Speicherzelle bei einem Winkel von θ = 135° anstelle von θ = 158°.

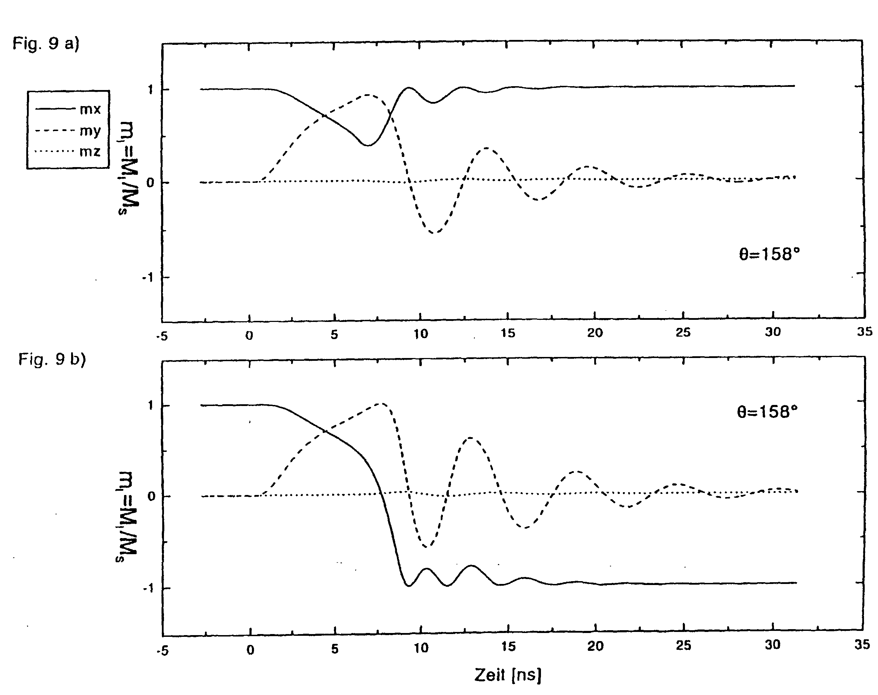

In Figur 9 wurde der Winkel θ = 158° aufgrund des Verhältnisses der Stromstärken der Magnetfelder parallel und senkrecht zur leichten Magnetisierung festgehalten. Die Magnetfeldstärke $H_p$ betrug -0,005 und die Magnetfeldstärke $H_s$ = 0,002.

Gemäß Figur 9a betrug die Pulsdauer der unipolaren Pulse sowohl senkrecht als auch parallel zur leichten Richtung der Magnetisierung 6,2 ns. Wie deutlich zu erkennen, reicht diese Pulsdauer nicht aus, um die Magnetisierung $m_x$ aus dem parallelen Zustand 1 in den antiparallelen Zustand -1 umzuschalten. Hierfür ist eine wesentlich längere Zeitdauer, wie in Figur 6b dargestellt, nötig. Ein Umschalten wird erreicht, wenn die Pulsdauer, wie in Figur 6b dargestellt, sowohl für die Richtung senkrecht wie parallel zur leichten Richtung der Magnetisierung 12,4 ns beträgt.

Wie hieraus deutlich zu erkennen, kann bei vorgegebenen Winkel θ eine Auswahl bzw. Adressierung einzelner Speicherbereiche allein dadurch erreicht werden, daß Pulsdauem entsprechend gewählt werden.

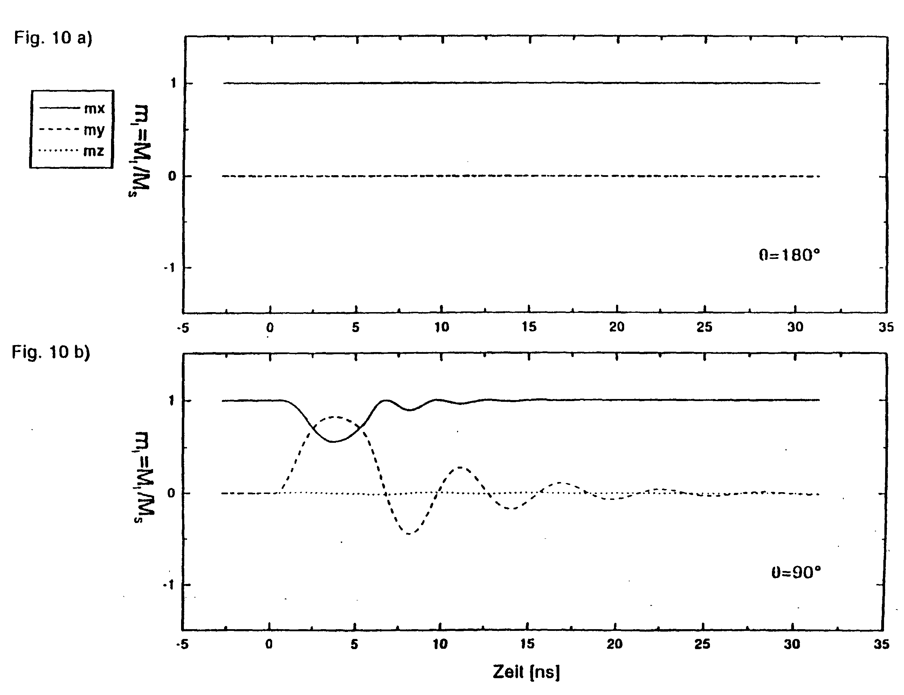

Wie aus Figur 10a und 10b hervorgeht, werden nur diejenigen Speicherzellen durch das erfindungsgemäße Verfahren angesprochen, in dem sich die stromführenden Leitungen kreuzen. Benachbarte Speicherzellen, durch die zwar ein Strom durch eine der Leitungen geführt wird, bleiben unbeeinflußt, da dort die Parameterkombination aus Feld, Feldrichtung und Zeit die Ummagnetisierung unmöglich macht. In Figur 10a beträgt der Winkel θ = 180°, d.h. es liegt ein Magnetfeld nur parallel zur leichten Richtung der Magnetisierung an, d.h. $H_p$ = -0,005, $H_s$ = 0. Ein Impuls von $T_s = T_p$ = 5 ns hat auf die Komponenten $m_x$, $m_y$, $m_z$ keinerlei Einfluß.

In Figur 10b ist der Verlauf der Magnetisierung $m_x$, $m_y$, $m_z$ für einen Strompuls, der ein Magnetfeld senkrecht zur leichten Richtung der Magnetisierung aufbaut, bei dem also θ = 90° ist, dargestellt. Die Pulsdauer beträgt $T_s = T_p$ = 5 ns, $H_p$ = 0, $H_s$ = 0,005. Nach einer gewissen Zeitdauer von 25 ns sind auch dort die Magnetisierungen im Zeitpunkt vor Auftreten des Strompulses wieder erreicht, ein Umschalten der $M_x$-Komponente wie in dem Bereich, in dem sich die stromführenden Leitungen kreuzen, findet nicht statt. Sämtliche zuvor gegebenen Feldangaben beziehen sich auf die Sättigungsmagnetisierung der weicheren Schicht 5, wobei beispielsweise -0,005 -0,5 % und 0,002 0,2 % der Sättigungsmagnetisierung der weicheren Schicht 5 bedeutet.

Mit dem erfindungsgemäßen Verfahren wird somit erstmals ein Verfahren angegeben, mit dem aufgrund einzelner Strompulse und geeigneter Wahl derselben im Verhältnis der Stromstärke sowie der Pulsdauer magnetische Speicherzellen zuverlässig und ohne Beeinflussung benachbarter Zellen in einem digitalen magnetischen Speicherarray angesprochen werden können. Hierbei werden schnelle Umschaltzeiten von weniger als 10 ns, bevorzugt weniger als 5 ns, realisiert, bei sehr niedrigen Stromsätzen. Gleichzeitig kann in einer besonders vorteilhaften Ausgestaltung der Erfindung die Dauer der Strompulse so gewählt werden, daß die zum Umschalten erforderliche Leistungsaufnahme minimiert wird.

**Patentansprüche**

1. Digitale magnetische Speicherzelleneinrichtung für Lese- und/oder Schreiboperationen mit

   1.1 einer ersten und einer zweiten magnetischen Schicht (3, 5), deren Magnetisierung zur Speicherung digitaler Informationen zueinander parallel oder antiparallel ausgerichtet ist, wobei mindestens eine der magnetischen Schichten eine magnetische Anisotropie aufweist;
   1.2 einer Zwischenschicht (7) zwischen erster und zweiter magnetischer Schicht sowie
   1.3 mindestens zwei sich kreuzenden Leiterbahnen (9, 11) zum Leiten von Lese- und Schreibströmen;
   1.4 Mittel zum Umschalten der Magnetisierung mindestens einer der magnetischen Schichten von einer parallelen in eine antiparallele Ausrichtung und umgekehrt; wobei
   1.5 die Umschaltmittel Einrichtungen (20, 22) zum Erzeugen von Strömen und/oder Strompulsen auf einer ersten und einer zweiten Leiterbahn der mindestens zwei sich kreuzenden Leiterbahnen umfassen, wobei sich
   1.6 die Leiterbahnen unter einem vorbestimmten Winkel β kreuzen, und wobei die Ströme in den Leiterbahnen so eingestellt werden, daß in den Speicherzelleneinrichtungen ein überlagertes Magnetfeld erzeugt wird, dessen Größe zu einem vollständigen und sicheren Umschalten der Magnetisierung von einer parallelen in eine antiparallele Ausrichtung oder umgekehrt führt,
   **dadurch gekennzeichnet, daß**
   1.7 in der Speicherzelleneinrichtung im Kreuzungsbereich Strompulse einer Pulsdauer < 10 ns angelegt werden, und
   1.8 daß die zum Umschalten notwendige Größe des Magnetfelds dadurch bestimmt wird, daß sie in einem gemäß der Landau-Lifschitz Gleichung erstellten Magnetfeldendpunkt-Diagramm in Bereiche des Umschaltens fällt, wobei die nachfolgenden Bedingungen gelten:
   1.8.1 die Magnetfeldendpunkte auf den Leiterbahnen (($\pm x_0$,0), (0,$\pm y_0$)) liegen im Bereich des Nichtumschaltens, d. h. auf den Leiterbahnen anliegenden Ströme führen in Speicherzellen, in denen sich die Leiterbahnen nicht kreuzen, zu keinem Umschalten
   1.8.2 in der Speicherzelle, in der sich die Leiterbahnen kreuzen, liegen die Magnetfeldendpunkte ($x_0$, $y_0$) im Bereich des Umschaltens
   1.8.3 alle Magnetfeldendpunkte (($\pm x_0$, 0), (0, $\pm y_0$); ($x_0$, $y_0$)) liegen möglichst weit entfemt von der Trennlinie zwischen Umschalten und Nichtumschalten.

2. Digitale Speicherzelleneinrichtung gemäß Anspruch 1, **dadurch gekennzeichnet, daß** der Winkel β = 90° ist, so daß die Leiterbahnen senkrecht aufeinander stehen.

3. Digitale Speicherzelleneinrichtung gemäß Anspruch 1, **dadurch gekennzeichnet, daß** der Winkel β aus nachfolgendem Bereich

$$0 < \beta < 90°$$

ausgewählt ist.

4. Digitale Speicherzelleneinrichtung gemäß Anspruch 1, **dadurch gekennzeichnet, daß** die sich kreuzenden Leiterbahnen zumindest auf einem Teilabschnitt parallel zueinander verlaufen.

5. Digitale Speicherzelleneinrichtung gemäß einem der Ansprüche 1 bis 4, **dadurch gekennzeichnet, daß** das Verhältnis der Stärke der Ströme und/oder Strompulse zueinander derart eingestellt wird, daß das Magnetfeld zum Umschalten der Magnetisierung einen vorbestimmten Winkel θ zur leichten Richtung der Magnetisierung der anisotropen Schicht aufweist.

6. Digitale Speicherzelleneinrichtung gemäß einem der Ansprüche 1 bis 5, **dadurch gekennzeichnet, daß** die Strompulse unipolare Pulse sind.

7. Digitale Speicherzelleneinrichtung gemäß einem der Ansprüche 1 bis 6, **dadurch gekennzeichnet, daß** auf der Leiterbahn, auf der der Strompuls ein Magnetfeld senkrecht zur leichten Magnetisierung erzeugt, ein bipolarer Puls anliegt und auf der anderen Leiterbahn ein statischer Strom oder ein Strompuls.

8. Digitale Speicherzelleneinrichtung gemäß einem der Ansprüche 1 bis 7, **dadurch gekennzeichnet, daß** die anisotrope erste magnetische Schicht eine uniaxiale magnetische Anisotropie aufgrund eines Wachstumsprozesses und/oder einer Formanisotropie aufweist.

9. Digitale Speicherzelleneinrichtung gemäß einem der Ansprüche 1 bis 8, **dadurch gekennzeichnet, daß** eine der beiden magnetischen Schichten magnetisch härter als die andere magnetische Schicht ist.

10. Verfahren zum Lesen/Schreiben digitaler Information in eine digitale Speicherzelleneinrichtung, durch Ändem der relativen Orientierung der Magnetisierung in einer der beiden magnetischen Schichten zueinander, wobei die Speicherzelleneinrichtung umfaßt:

eine erste und eine zweite magnetische Schicht (3, 5), deren Magnetisierung zur Speicherung digitaler Information zueinander parallel oder antiparallel ausgerichtet ist sowie eine Zwischenschicht zwischen erster und zweiter magnetischer Schicht und mindestens zwei sich kreuzende Leiterbahnen zum Leiten von Lese- und Schreibströmen,
mit nachfolgenden Schritten:

10.1 es werden auf den mindestens zwei sich kreuzenden Leiterbahnen Ströme und/oder Strompulse angelegt, wobei die Ströme in den Leiterbahnen so eingestellt werden, daß in den Speicherzelleneinrichtungen ein überlagertes Magnetfeld erzeugt wird, dessen Größe zu einem vollständigen und sicheren Umschalten der Magnetisierung von einer parallelen in eine antiparallele Ausrichtung oder umgekehrt führt, **dadurch gekennzeichnet**,
10.2 in der Speicherzelleneinrichtung im Kreuzungsbereich Strompulse einer Pulsdauer < 10 ns angelegt werden, und
10.3 daß die zum Umschalten notwendige Größe des Magnetfelds dadurch bestimmt wird, daß sie in einem gemäß der Landau-Lifschitz Gleichung erstellten Magnetfeldendpunkt-Diagramm in Bereiche des Umschaltens fällt, wobei die nachfolgenden Bedingungen gelten:

10.4.1 die Magnetfeldendpunkte auf den Leiterbahnen $((\pm X_0, 0), (0, \pm y_0))$ liegen im Bereich des Nichtumschaltens, d. h. auf den Leiterbahnen anliegenden Ströme führen in Speicherzellen, in denen sich die Leiterbahnen nicht kreuzen, zu keinem Umschalten

10.4.2 in der Speicherzelle, in der sich die Leiterbahnen kreuzen, liegen die Magnetfeldendpunkte $(x_0, y_0)$ im Bereich des Umschaltens

10.4.3 alle Magnetfeldendpunkte $((\pm x_0, 0), (0, \pm y_0); (x_0, Y_0))$ liegen möglichst weit entfernt von der Trennlinie zwischen Umschalten und Nichtumschalten.

11. Verfahren gemäß Anspruch 10, **dadurch gekennzeichnet, daß** der vorbestimmte Winkel θ gegenüber der leichten Magnetisierung durch das Verhältnis der Stromstärken der Stromimpulse bzw. des Stromimpulses und/oder Ströme zueinander eingestellt wird.

12. Verfahren gemäß einem der Ansprüche 10 bis 11, **dadurch gekennzeichnet, daß** die Strompulse unipolare Pulse sind.

13. Verfahren gemäß einem der Ansprüche 10 bis 12, **dadurch gekennzeichnet, daß** der Strompuls auf der Leiterbahn, bei der der Stromfluß ein Magnetfeld senkrecht zur leichten Magnetisierung erzeugt, ein bipolarer Strompuls ist und auf der anderen Leiterbahn ein statischer Strom oder Strompuls anliegt.

14. Verfahren gemäß Anspruch 13, **dadurch gekennzeichnet, daß** die Zeitdauer des Strompulses auf der anderen Leiterbahn größer ist als die Halbwellendauer des bipolaren Strompulses auf der Leiterbahn, bei der der Stromfluß ein Magnetfeld senkrecht zur Richtung der leichten Magnetisierung erzeugt.

15. Verfahren gemäß einem der Ansprüche 10 bis 14, **dadurch gekennzeichnet, daß** die Pulsdauer der Strompulse des weiteren derart gewählt wird, daß ein vollständiges Umschalten bei gleichzeitig minimaler Leistungsaufnahme erreicht wird.

16. Digitale Speichereinrichtung umfassend eine Vielzahl von Speicherzelleneinrichtungen gemäß einem der Ansprüche 1 bis 9, **dadurch gekennzeichnet, daß** sich im Bereich jeder Speicherzelleneinrichtung mindestens zwei Leiterbahnen kreuzen.

17. Digitale Speichereinrichtung gemäß Anspruch 16, **dadurch gekennzeichnet, daß** die Dauer des Stromimpulses kleiner 10 ns ist und daß das Verhältnis der Stärke der Ströme und/oder Strompulse, ergebend den Winkel θ, deart gewählt wird, daß ein vollständiges Umschalten der Magnetisierung in einer einzigen vorgegebenen Speicherzelleneinrichtung ohne Beeinflussung des Zustandes der Nachbarzellen erfolgt.

18. Digitale Speichereinrichtung gemäß einem der Ansprüche 16 bis 17, **dadurch gekennzeichnet, daß** die Dauer der Strompulse des weiteren derart gewählt wird, daß ein vollständiges Umschalten bei gleichzeitig minimaler Leistungsaufnahme erreicht wird.

19. Digitale Speichereinrichtung gemäß einem der Ansprüche 16 bis 18, **dadurch gekennzeichnet, daß** die Vielzahl von Speicherzelleneinrichtungen in Matrixform angeordnet sind.

20. Digitale Speichereinrichtung gemäß Anspruch 19, **dadurch gekennzeichnet, daß** einer Mehrzahl von in Reihe und/oder Spalten angeordneten Leiterbahnen von in Matrixform angelegten Speicherzelleneinrichtungen gemeinsame Umschaltmittel zugeordnet sind.

21. Digitale Speichereinrichtung gemäß einem der Ansprüche 17 bis 20, **dadurch gekennzeichnet, daß** die magnetisch härtere Schicht eine über mehrere Speicherzellen durchgehende Schicht ist.

22. Verfahren zum Lesen/Schreiben digitaler Information in eine digitale Speichereinrichtung gemäß einem der Ansprüche 16 bis 21, **dadurch gekennzeichnet, daß** mittels eines Verfahrens gemäß einem der Ansprüche 10 bis 15 die Speicherzelleneinrichtung aus der Vielzahl von Speicherzelleneinrichtungen, in der sich die Leiterbahnen kreuzen, auf denen die Ströme und/oder Strompulse anliegen, ausgewählt wird und durch Ändern der relativen Orientierung der Magnetisierung in einer der beiden Schichten dieser Speicherzelleneinrichtung digitaler Informationen in diese geschrieben oder ausgelesen werden, ohne daß hierdurch benachbarte Zellen beeinflußt werden.

**Claims**

1. Digital magnetic memory cell system for reading and/or writing operations with

   1.1 a first and a second magnetic layer (3, 5) of which the magnetisation is orientated in a mutually parallel or antiparallel manner for the storage of digital information, at least one of the magnetic layers comprising magnetic anisotropy;

   1.2 an interlayer (7) between first and second magnetic layer and

   1.3 at least two intersecting conductors (9, 11) for conducting reading and writing currents;

   1.4 means for switching the magnetisation of at least one of the magnetic layers from a parallel orientation to an antiparallel orientation or vice versa; wherein

   1.5 the switching means comprise devices (20, 22) for producing currents and/or current pulses on a first and a second conductor of the at least two intersecting conductors, wherein

   1.6 the conductors intersect at a predetermined angle $\beta$ and wherein the currents in the conductors are so adjusted that a superimposed magnetic field is produced in the memory cell systems, the value of the magnetic field leading to a complete and reliable switch in the magnetisation from a parallel orientation to an antiparallel orientation or vice versa,
   **characterised in that**

   1.7 current pulses having a pulse duration < 10 ns are applied in the intersection region in the memory cell system and

   1.8 **in that** the value of the magnetic field required for switching is determined in such a way that it falls in regions of the switch in a magnetic field end point graph produced in accordance with the Landau-Lifschitz equation, the following conditions applying:

   1.8.1 the magnetic field end points on the conductors $((\pm x_0, 0), (0, \pm y_0))$ lie in the non-switching region, i.e. currents applied to the conductors do not lead to switching in memory cells in which the conductors do not intersect
   1.8.2 the magnetic field end points $(x_0, y_0)$ lie in the switching region in the memory cell in which the conductors intersect
   1.8.3 all magnetic field end points $((\pm x_0, 0), (0, \pm y_0); (x_0, y_0))$ lie as far away as possible from the parting line between switching and non-switching.

2. Digital memory cell system according to claim 1, **characterised in that** the angle $\beta = 90°$ so the conductors are perpendicular to one another.

3. Digital memory cell system according to claim 1, **characterised in that** the angle $\beta$ is selected from the following range $0 < \beta < 90°$.

4. Digital memory cell system according to claim 1, **characterised in that** the intersecting conductors extend in a mutually parallel manner at least over a portion.

5. Digital memory cell system according to any of claims 1 to 4, **characterised in that** the ratio of the strength of the currents and/or current pulses to one another is adjusted in such a way that the magnetic field for switching the magnetisation has a predetermined angle $\theta$ for easy orientation of the magnetisation of the anisotropic layer.

6. Digital memory cell system according to any of claims 1 to 5, **characterised in that** the current pulses are unipolar pulses.

7. Digital memory cell system according to any of claims 1 to 6, **characterised in that** a bipolar pulse is applied to the conductor on which the current pulse produces a magnetic field perpendicular to light magnetisation and a static current or a current pulse is applied to the other conductor.

8. Digital memory cell system according to any of claims 1 to 7, **characterised in that** the anisotropic first magnetic layer has uniaxial magnetic anisotropy owing to a growth process and/or anisotropy in shape.

9. Digital memory cell system according to any of claims 1 to 8, **characterised in that** one of the two magnetic layers is magnetically harder than the other magnetic layer.

10. Method of reading/writing digital information into a digital memory cell system by changing the relative orientation of the magnetisation in one of the two magnetic layers relative to one another, wherein the memory cell system comprises:

   a first and a second magnetic layer (3, 5) of which the magnetisation is orientated in a mutually parallel or antiparallel manner for storing digital information and an interlayer between first and second magnetic layer and at least two intersecting conductors for conducting reading and writing currents,

   with the following steps:

   10.1 currents and/or current pulses are applied to the at least two intersecting conductors, the currents in the conductors being adjusted in such a way that a superimposed magnetic field is produced in the memory cell systems, the value of the magnetic field leading to complete and reliable switching of the magnetisation from a parallel to an antiparallel orientation or vice versa, **characterised in that**

   10.2 current pulses having a pulse duration < 10 ns are applied in the intersection region in the memory cell system and

   10.3 **in that** the value of the magnetic field required for switching is determined in such a way that it falls in regions of the switch in a magnetic field end point graph produced in accordance with the Landau-Lifschitz equation, the following conditions applying:

   10.4.1 the magnetic field end points on the conductors $((\pm x_0, 0), (0, \pm y_0))$ lie in the non-switching region, i.e. currents applied to the conductors do not lead to switching in memory cells in which the conductors do not intersect

   10.4.2 the magnetic field end points $(x_0 \, y_0)$ lie in the switching region in the memory cell in which the conductors intersect

   10.4.3 all magnetic field end points $((\pm x_0, 0), (0, \pm y_0); (x_0, y_0))$ lie as far away as possible from the parting line between switching and non-switching.

11. Method according to claim 10, **characterised in that** the predetermined angle θ is adjusted relative to the light magnetisation by the ratio of the current strengths of the current pulses or the current pulse and/or currents relative to one another.

12. Method according to any of claims 10 to 11, **characterised in that** the current pulses are unipolar pulses.

13. Method according to any of claims 10 to 12, **characterised in that** the current pulse on the conductor, during which the current flux produces a magnetic field perpendicular to the light magnetisation is a bipolar current pulse and a static current or current pulse is applied to the other conductor.

14. Method according to claim 13, **characterised in that** the duration of the current pulse on the other conductor is greater than the half-wave duration of the bipolar current pulse on the conductor during which the current flux produces a magnetic field perpendicular to the direction of light magnetisation.

15. Method according to any of claims 10 to 14, **characterised in that** the pulse duration of the current pulses is also selected in such a way that a complete switch is achieved when the power consumption is simultaneously at a minimum.

16. Digital memory cell system comprising a large number of memory cell systems according to any of claims 1 to 9, **characterised in that** at least two conductors intersect in the region of each memory cell system.

17. Digital memory cell system according to claim 16, **characterised in that** the duration of the current pulse is shorter than 10 ns and **in that** the ratio of the strength of the current and/or current pulses producing the angle θ is selected in such a way that a complete switch of magnetisation takes place in a single predetermined memory cell system without influencing the state of the neighbouring cells.

18. Digital memory cell system according to either of claims 16 to 17, **characterised in that** the duration of the current pulses is also selected in such a way that a complete switch is achieved when the power consumption is simultaneously at a minimum.

19. Digital memory cell system according to any of claims 16 to 18, **characterised in that** the large number of memory cell systems is arranged in matrix form.

20. Digital memory cell system according to claim 19, **characterised in that** common switching means are assigned to a plurality of conductors arranged in rows and/or columns of memory cell systems applied in matrix form.

21. Digital memory cell system according to any of claims 17 to 20, **characterised in that** the magnetically harder layer is a layer which is continuous over a plurality of memory cells.

22. Method of reading/writing digital information into a digital memory cell system according to any of claims 16 to 21 **characterised in that**, using a method according to any of claims 10 to 15, the memory cell system is selected from the large number of memory cell systems in which the conductors, to which the currents and/or current pulses are applied, intersect and, by changing the relative orientation of the magnetisation in one of the two layers of this memory cell system, digital information is written into or read from this memory cell systems without thereby affecting neighbouring cells.

**Revendications**

1. Dispositif de cellules mémoire numérique magnétique pour opérations de lecture et/ou d'écriture avec

> 1.1 une première et une deuxième couche magnétique (3, 5) dont la magnétisation pour la mise en mémoire d'informations numériques présente une orientation parallèle ou antiparallèle, au moins une des couches magnétiques présentant une anisotropie magnétique ;
> 1.2 une couche intermédiaire (7) entre la première et la deuxième couche magnétique et
> 1.3 au moins deux pistes conductrices (9, 11) qui se croisent et sont destinées à assurer le passage des courants de lecture et d'écriture ;
> 1.4 des moyens pour faire basculer la magnétisation d'au moins une des couches magnétiques d'une orientation parallèle à une orientation antiparallèle ou inversement;
> 1.5 les moyens de basculement comprenant des dispositifs (20, 22) pour générer des courants et/ou des impulsions de courant sur une première et une deuxième piste conductrice des pistes conductrices qui se croisent et sont au moins au nombre de deux,
> 1.6 les pistes conductrices se croisant à un angle prédéterminé β, les courants dans les pistes conductrices étant ajustés de telle sorte que, dans les dispositifs de cellules mémoire, un champ magnétique superposé est créé dont la magnitude conduit à un basculement total et fiable de la magnétisation d'une orientation parallèle à une orientation antiparallèle ou inversement, **caractérisé en ce que**,
> 1.7 dans la zone de croisement dans le dispositif de cellules mémoire, des impulsions de courant d'une durée d'impulsion < 10 ns sont appliquées et
> 1.8 que la magnitude du champ magnétique nécessaire au basculement est déterminée par le fait qu'elle entre, dans un diagramme des points d'extrémité du champ magnétique établi d'après l'équation de Landau-Lifschitz, dans des zones de basculement, et que ceci satisfait aux conditions suivantes:

> > 1.8.1 les points d'extrémité du champ magnétique sur les pistes conductrices ($\pm x_0$, 0), (0, $\pm y_0$)) sont situés dans la zone dans laquelle il n'y a pas de basculement, c'est-à-dire que des courants appliqués sur les pistes conductrices ne conduisent pas à un basculement dans des cellules mémoire dans lesquelles les pistes conductrices ne se croisent pas
> > 1.8.2 dans la cellule mémoire dans laquelle les pistes conductrices se croisent, les points d'extrémité du champ magnétique ($x_0$, $y_0$) se situent dans la zone de basculement
> > 1.8.3 tous les points d'extrémité du champ magnétique (($\pm x_0$, 0), (0, $\pm y_0$); ($x_0$, $y_0$)) se situent le plus loin possible de la ligne de séparation entre le basculement et le non-basculement.

**2.** Dispositif de cellules mémoire numérique selon la revendication 1, **caractérisé en ce que** l'angle β = 90° de sorte que les pistes conductrices sont perpendiculaires.

**3.** Dispositif de cellules mémoire numérique selon la revendication 1, **caractérisé en ce que** l'angle β est choisi entre 0 et 90°.

**4.** Dispositif de cellules mémoire numérique selon la revendication 1, **caractérisé en ce que** les pistes conductrices qui se croisent sont parallèles du moins en partie.

**5.** Dispositif de cellules mémoire numérique selon l'une des revendications 1 à 4, **caractérisé en ce que** le rapport de l'intensité des courants et/ou des impulsions de courant est ajusté de telle sorte que le champ magnétique pour le basculement de la magnétisation est à un angle prédéterminé θ par rapport à la direction de la faible magnétisation de la couche anisotrope.

**6.** Dispositif de cellules mémoire numérique selon l'une des revendications 1 à 5, **caractérisé en ce que** les impulsions de courant sont des impulsions unipolaires.

**7.** Dispositif de cellules mémoire numérique selon l'une des revendications 1 à 6, **caractérisé en ce qu'**une impulsion bipolaire est appliquée sur la piste conductrice sur laquelle l'impulsion de courant crée un champ magnétique perpendiculaire à la faible magnétisation, et qu'un courant ou une impulsion de courant statique est appliquée sur l'autre piste conductrice.

**8.** Dispositif de cellules mémoire numérique selon l'une des revendications 1 à 7, **caractérisé en ce que** la première couche magnétique anisotrope présente une anisotropie magnétique uniaxiale en raison d'une croissance et/ou d'une anisotropie de forme.

**9.** Dispositif de cellules mémoire numérique selon l'une des revendications 1 à 8, **caractérisé en ce que** l'une des deux couches magnétiques est magnétiquement plus dure que l'autre couche magnétique.

**10.** Procédé de lecture et d'écriture d'information numérique dans un dispositif de cellules mémoire numérique consistant à modifier l'orientation relative de la magnétisation dans l'une des deux couches magnétiques, le dispositif de cellules mémoire comprenant:

une première et une deuxième couche magnétique (3, 5) dont la magnétisation pour la mise en mémoire d'informations numériques
présente une orientation parallèle ou antiparallèle ainsi qu'une couche intermédiaire entre la première et la deuxième couche magnétique et au moins deux pistes conductrices qui se croisent et sont destinées à assurer le passage des courants de lecture et d'écriture,
ledit procédé comprenant les étapes suivantes:

10.1. des courants et/ou impulsions de courant sont appliqués sur les pistes conductrices qui se croisent et sont au moins au nombre de deux, les courants dans les pistes conductrices étant ajustés de manière à créer, dans les dispositifs de cellules mémoire, un champ magnétique superposé dont la magnitude conduit à un basculement total et fiable de la magnétisation d'une orientation parallèle à une orientation antiparallèle ou inversement, **caractérisé en ce que**,
10.2 dans la zone de croisement dans le dispositif de cellules mémoire, des impulsions de courant d'une durée d'impulsion < 10 ns sont appliquées et
10.3 que la magnitude du champ magnétique nécessaire au basculement est déterminée par le fait qu'elle entre, dans un diagramme des points d'extrémité du champ magnétique établi d'après l'équation de Landau-Lifschitz, dans des zones de basculement, et que ceci satisfait aux conditions suivantes:

10.4.1 les points d'extrémité du champ magnétique sur les pistes conductrices $((\pm x_0, 0), (0, \pm y_0))$ sont situés dans la zone dans laquelle il n'y a pas de basculement, c'est-à-dire que des courants appliqués sur les pistes conductrices ne conduisent pas à un basculement dans des cellules mémoire dans lesquelles les pistes conductrices ne se croisent pas
10.4.2 dans la cellule mémoire dans laquelle les pistes conductrices se croisent, les points d'extrémité

du champ magnétique ($x_0$, $y_0$) se situent dans la zone de basculement

10.4.3 tous les points d'extrémité du champ magnétique (($\pm x_0$, 0), (0, $\pm y_0$); ($x_0$, $y_0$)) se situent le plus loin possible de la ligne de séparation entre le basculement et le non-basculement.

**11.** Procédé selon la revendication 10, **caractérisé en ce que** l'angle prédéterminé θ par rapport à la faible magnétisation est ajusté par le rapport des intensités de courant des impulsions de courant ou de l'impulsion de courant et/ou des courants entre eux.

**12.** Procédé selon l'une des revendications 10 à 11, **caractérisé en ce que** les impulsions de courant sont des impulsions unipolaires.

**13.** Procédé selon l'une des revendications 10 à 12, **caractérisé en ce que** l'impulsion de courant sur la piste conductrice, sur laquelle le flux de courant crée un champ magnétique perpendiculaire à la faible magnétisation, est une impulsion de courant bipolaire et qu'un courant ou une impulsion de courant statique est appliqué sur l'autre piste conductrice.

**14.** Procédé selon la revendication 13, **caractérisé en ce que** la durée de l'impulsion de courant sur l'autre piste conductrice est supérieure à la durée de la demi-onde de l'impulsion bipolaire sur la piste conductrice sur laquelle le flux de courant crée un champ magnétique perpendiculaire à la direction de la faible magnétisation.

**15.** Procédé selon l'une des revendications 10 à 14, **caractérisé en ce que** la durée d'impulsion des impulsions de courant est en outre choisie de manière à permettre le basculement total tout en absorbant le moins d'énergie possible.

**16.** Dispositif de cellules mémoire numérique comprenant un grand nombre de dispositifs de cellules mémoire selon l'une des revendications 1 à 9, **caractérisé en ce qu'**au moins deux pistes conductrices se croisent dans la région de chacun des dispositifs de cellules mémoire.

**17.** Dispositif de cellules mémoire selon la revendication 16, **caractérisé en ce que** la durée de l'impulsion de courant est inférieure à 10 ns et que le rapport de l'intensité des courants et/ou des impulsions de courant, qui donne l'angle θ, est choisi de manière à permettre le basculement total de la magnétisation dans un seul dispositif de cellules mémoire prédéterminé sans rien changer pour autant à l'état des cellules voisines.

**18.** Dispositif de cellules mémoire numérique selon l'une des revendications 16 à 17, **caractérisé en ce que** la durée des impulsions de courant est de plus choisie de manière à permettre un basculement total tout en absorbant le moins d'énergie possible.

**19.** Dispositif de cellules mémoire numérique selon l'une des revendications 16 à 18, **caractérisé en ce que** le grand nombre de dispositifs de cellules mémoire est disposé sous forme de matrice.

**20.** Dispositif de cellules mémoire numérique selon la revendication 19, **caractérisé en ce que** des moyens de basculement communs sont associés à une majorité de pistes conductrices disposées en lignes et/ou colonnes dans des dispositifs de cellules mémoire disposés sous forme de matrice.

**21.** Dispositif de cellules mémoire numérique selon l'une des revendications 17 à 20, **caractérisé en ce que** la couche magnétiquement plus dure est une couche qui traverse plusieurs cellules mémoire.

**22.** Procédé de lecture/écriture d'informations numériques dans un dispositif de mémoire numérique selon l'une des revendications 16 à 21, **caractérisé en ce que**, au moyen d'un procédé selon l'une des revendications 10 à 15, le dispositif de cellules mémoire est choisi parmi le grand nombre de dispositifs de cellules mémoire dans lesquelles les pistes conductrices sur lesquelles sont appliqués les courants et/ou les impulsions de courant se croisent et que les informations numériques sont inscrites ou lues dans ledit dispositif de cellules mémoire en modifiant l'orientation relative de la magnétisation dans l'une des deux couches de ce dispositif de cellules mémoire sans pour autant influencer les cellules voisines.

Fig. 1 a)

Fig. 1 b)

Fig. 2

Fig. 3 a)

Fig. 3 b)

Fig. 3 c)

$t_{Pulse}$ = 0.75 ns

Fig. 3 d)

$t_{Pulse}$ = 10.0 ns

Fig. 3 e)

Fig. 4 a)

H_y [Oe]

198

• c

b

H_x [Oe]

d

• e

Fig. 4 b)

Fig. 4 c)

Fig. 4 d)

Fig. 4 e)

EP 1 082 725 B1

Fig. 5 a)

Fig. 5 b)

Fig. 5 c)

Fig. 5 d)

Fig. 5 e)

$t_{pulse} = 0.25$ ns

Fig.
6 a)

Präzessionsdominiert

198                                    198

$t_{pulse} = 1.40$ ns

Fig.
6 b)

Übergangsbereich

198                                    198

198                                    198

$t_{pulse} = 2.75$ ns

Fig.
6 c)

Dämpfungsdominiert

Fig. 7

$$\vec{H}(t) = \begin{pmatrix} H_x(t) \\ H_y(t) \\ H_z(t) \end{pmatrix} = \begin{pmatrix} H_p(t) \\ H_S(t) \\ 0 \end{pmatrix}$$

$$\vec{M}(t) = \begin{pmatrix} M_x(t) \\ M_y(t) \\ M_z(t) \end{pmatrix}$$

Fig. 8 a)

θ=158°

Legend:
mx (solid line)
my (dashed line)
mz (dotted line)

$m_i = M_i/M_s$

Fig. 8 b)

θ=135°

$m_i = M_i/M_s$

Zeit [ns]

EP 1 082 725 B1

31

Fig. 9 a)

Fig. 9 b)

Fig. 10 a)

Fig. 10 b)

Zeit [ns]